# EUROPEAN PATENT SPECIFICATION

(11) **EP 4 352 775 B1**
(45) Date of publication and mention of the grant of the patent: **23.09.2026**
(21) Application number: 22811858.4
(22) Date of filing: 16.05.2022
(51) Int. Cl.: H01J 37/32

(54) **MULTI-SECTIONAL PLASMA CONFINEMENT RING STRUCTURE**
MEHRTEILIGE PLASMABEGRENZUNGSRINGSTRUKTUR
STRUCTURE ANNULAIRE DE CONFINEMENT DE PLASMA À SECTIONS MULTIPLES

(30) Priority: 24.05.2021 US 202163192511 P
(43) Date of publication of application: 17.04.2024
(73) Proprietor: Lam Research Corporation, Fremont, CA 94538 (US)
(72) Inventor: MARAKHTANOV, Alexei, Fremont, CA 94538 (US); KELLOGG, Michael C., Fremont, CA 94538 (US)
(74) Representative: Mewburn Ellis LLP
(86) International application number: PCT/US2022/029494
(87) International publication number: WO 2022/250998

(56) References cited:
- JP-A- H0 882 689
- KR-A- 20180 048 681
- US-A1- 2011 100 553
- US-A1- 2012 000 608
- US-A1- 2013 008 605
- US-A1- 2013 133 834
- US-A1- 2020 051 792
- US-A1- 2020 075 295
- US-A1- 2020 243 307

## Description

The invention relates to a confinement ring design used in a semiconductor processing module.

### BACKGROUND

In semiconductor processing, a substrate undergoes various operations to form features that define integrated circuits. For example, in a deposition operation, the substrate is received into a processing chamber and, depending on type of feature to be formed, specific types of reactive gases are supplied to the chamber and a radio frequency power is applied to generate plasma. The substrate is received on a substrate support defined on a lower electrode, such as an electro static chuck. An upper electrode, such as a showerhead, is used to provide the specific types of reactive gases into the process chamber. The radio frequency power is applied to the reactive gases through a corresponding match network to generate the plasma used to selectively deposit ions over a surface of the substrate to form microscopic features. The reactive gases generate by-products, such as particulates, gases, etc., which need to be promptly removed from the plasma chamber in order to maintain the integrity of the microscopic features formed on the surface of the substrate.

To confine the generated plasma within a process region, a set of confinement rings are defined to surround the process region. Further, to improve the yield and to ensure the bulk of the plasma is over the substrate received for processing, the confinement rings surrounding the plasma region may be designed to extend the process region so as to cover not only the region above the substrate but also the region over an edge ring disposed to surround the substrate, when received for processing, and an outer confinement ring disposed adjacent to the edge ring. The set of confinement rings not only act to confine the plasma within the process region but also act to protect the inside structure of the processing chamber, including chamber walls. The set of confinement rings are generally C-shaped structure (i.e., C-shroud).

The integrity of the features formed on the surface of the substrate relies on uniform plasma density in the process region. Plasma uniformity can be modulated by adjusting the shape of the set of confinement rings (e.g., C-shroud) to increase the volume of the process region, as disclosed in US 2020/075295 A1, US 2011/100553 A1 and US 2013/133834 A1. Any changes to the shape or design of the confinement rings have to ensure that the changes do not compromise the mechanical strength or reduce the lifetime of the confinement rings. Further, it would be advantageous if the changes to the shape or design of the confinement rings do not require changes to the hardware used within the processing chamber, such as processing chamber spacer plate, mating hardware, etc. US 2020/051792 A1 discloses a monolithic C-shaped plasma confinement ring and its L-shaped alternative for a plasma chamber.

It is in this context that embodiments of the invention arise.

### SUMMARY

The invention is defined by the appended claims.

Various implementations of the invention define a design of a confinement ring used in a plasma processing chamber for confining plasma within a plasma region. The confinement ring is coupled to an upper electrode structure disposed in a top portion of the plasma processing chamber and is designed to have an S-shaped structure. The S-shaped confinement ring, according to some implementations, is defined to include an upper horizontal section, an upper vertical section, a mid-section, a lower vertical section, a lower horizontal section and a vertical extension. The upper horizontal section is defined to extend between a first outer radius and an inner upper radius. The mid-section is defined to extend between the inner upper radius and a second outer radius. The lower horizontal section is defined to extend between the second outer radius and an inner lower radius. The upper vertical section is defined to extend between the upper horizontal section and the mid-section at the inner upper radius and the lower vertical section is defined to extend between the mid-section and the lower horizontal section at the second outer radius. A vertical extension is defined to extend down from the lower horizontal section at the inner lower radius.

The S-shaped structure of the confinement ring assists in improving radial plasma density uniformity while keeping the gas conductance the same as the traditional confinement rings (i.e., C-shaped confinement rings). Further, the S-shape assists in reducing volume of the plasma in the plasma region while improving the substrate radial etch uniformity. Additional design configurations, such as including a slope in the bottom surface of the mid-section, and/or a slope in the top surface of the lower horizontal section, and/or sloped lower horizontal section, etc., may also be considered to improve radial plasma density uniformity, reduce volume and improve etch uniformity. The S-shaped structure helps in modulating the plasma density uniformity within the plasma region without requiring re-design of other hardware components of the plasma processing chamber. Further, the S-shaped design of the confinement ring ensures that the mechanical strength is preserved and the lifetime of the consumable confinement ring is maintained or improved.

The lower horizontal section includes a plurality of slots (also referred to as "conductance slots") defined along the length of the lower horizontal section for removing the by-products and neutral gas species generated within the plasma region. The plurality of slots is designed to ensure optimal confinement of the plasma in the plasma region. Each slot is defined to extend radially from an inner diameter to an outer diameter along the lower horizontal section and vertically between the top surface and the bottom surface of the lower horizontal section. In some implementations, each slot of the plurality of slots is defined to include parallel slot geometry, wherein an inner slot radius defined at the inner diameter is equal to an outer slot radius defined at the outer diameter. In alternate implementations, each slot of the plurality of slots is defined using tapered slot geometry, wherein the inner slot radius defined at the inner diameter is smaller than the outer slot radius defined at the outer diameter.

The tapered slot geometry is designed to address the differential wear experienced along the length of the slots due to constant exposure to the plasma. Typically, the wear of the slot is greater at the inner diameter than at the outer diameter. This uneven wear may be attributed to the variance in the volume of plasma near the inner diameter of the slot as opposed to the outer diameter. When the wear reaches critical dimension, the confinement ring needs to be promptly replaced to ensure that a plasma unconfinement event does not occur. The tapered slot geometry makes efficient use of the area around the slot by defining a narrow end at the inner diameter thereby providing more area for wear and a broader end at the outer diameter providing less area for wear. This tapered geometry allows the narrow end to experience greater wear so that the wear at the narrow end of the slot approaches the critical dimension at about the same time as the broader end of the slot, resulting in the entire slot length reaching the critical confinement dimension at end of life. The tapered slot geometry efficiently manages the limited space between the slots resulting in extended usage life of the confinement ring while maintaining optimal plasma confinement within the plasma region. Consequently, the cost associated with the consumable confinement ring is lowered as the number of process cycles the confinement ring can be used in the plasma processing chamber is extended. The S-shaped structure of the confinement ring provides the additional advantage of improving plasma density uniformity with less volume and does not require re-design of other hardware components of the plasma processing chamber.

In one implementation, a confinement ring for use in a plasma processing chamber is disclosed. The confinement ring includes an upper horizontal section, an upper vertical section, a mid-section, a lower vertical section, a lower horizontal section and a vertical extension. The upper horizontal section extends between an inner upper radius and a first outer radius. The mid-section extends between the inner upper radius and a second outer radius. The lower horizontal section extends between an inner lower radius and the second outer radius of the confinement ring. The upper vertical section extends between the upper horizontal section and the mid-section proximate to the inner upper radius. The lower vertical section extends between the mid-section and the lower horizontal section proximate to the second outer radius. The vertical extension extends downward proximate to the inner lower radius.

In one implementation, a plasma volume is disposed between an upper electrode structure, a lower electrode and the confinement ring.

In one implementation, an external volume is defined between the upper horizontal section, the upper vertical section and the mid section. The external volume is outside of the plasma volume.

In one implementation, an internal volume is defined between the mid-section, the lower vertical section and the lower horizontal section. The internal volume is inside the plasma volume.

In one implementation, an external volume is defined between the upper electrode structure, the upper vertical section and the mid-section, and an internal volume is defined between the mid-section, the lower vertical section and the lower horizontal section. The internal volume is inside a plasma volume of the plasma processing chamber and the external volume is outside of the plasma volume. The external volume reduces the plasma volume.

In one implementation, the upper horizontal section, the upper vertical section, the mid-section, the lower vertical section and the lower horizontal section together define an S-shaped structure.

In one implementation, a length of the mid-section and a length of the lower horizontal section are of a uniform thickness.

In one implementation, a top surface of the mid-section includes a flat profile and a bottom surface of the mid-section is angled down from the inner upper radius toward the second outer radius, so that a first thickness of the mid-section proximate to the inner upper radius is less than a second thickness of the mid-section proximate to the second outer radius.

In one implementation, a first height defined between a top surface of the lower horizontal section and a bottom surface of the mid-section proximate to the second outer radius is less than a second height defined between a top surface of the mid-section and a bottom surface of the upper horizontal section proximate to the inner upper radius.

In one implementation, a first height defined between a top surface of the lower horizontal section and a bottom surface of the mid-section proximate to the second outer radius is equal to a second height defined between a top surface of the mid-section and a bottom surface of the upper horizontal section proximate to the inner upper radius and to a third height defined between the top surface of the lower horizontal section and the bottom surface of the mid-section proximate to the inner upper radius.

In one implementation, the second outer radius extends beyond the first outer radius, the second outer radius defines an outer radius of the confinement ring, and the inner upper radius is greater than the inner lower radius.

In one implementation, the lower horizontal section includes a plurality of slots. Each slot of the plurality of slots extends radially from an inner diameter to an outer diameter along the lower horizontal section. The inner diameter of the slot is greater than an inner ring diameter of the confinement ring defined by the inner lower radius, and the outer diameter of the slot is less than an outer ring diameter of the confinement ring defined by the second outer radius. Each slot extends from a top surface to a bottom surface of the lower horizontal section.

In one implementation, an inner slot radius of each slot at the inner diameter is less than an outer slot radius of each slot at the outer diameter. A difference in the inner slot radius and the outer slot radius of each slot defines a slot taper. Each slot tapers down from the outer diameter to the inner diameter. The inner slot radius and the outer slot radius influencing the slot taper are defined to be an inverse of a wear rate at the corresponding inner diameter and the outer diameter of the slot.

In one implementation, a ratio of the inner slot radius to the outer slot radius is between about 1:1.1 and about 1:1.5.

In one implementation, an inner slot radius of each slot at the inner diameter is equal to an outer slot radius of each slot at the outer diameter.

In one implementation, a first height of the first vertical section is equal to a second height of the second vertical section.

In one implementation, a first height of the first vertical section is different from a second height of the second vertical section.

In one implementation, wherein the upper horizontal section, the upper vertical section, the mid-section, the lower vertical section and the lower horizontal section form a unitary S-shaped structure, and the vertical extension integrally continues the S-shaped structure downward proximate to the inner lower radius. The unitary S-shaped structure is configured to confine plasma within a plasma region defined in the plasma processing chamber.

In one implementation, the upper horizontal section, the upper vertical section, the mid-section, and the lower vertical section define a first unitary piece and the lower horizontal section defines a second piece. The first unitary piece is configured to be received over a radio frequency gasket defined on a top surface proximate to the second outer radius of the second piece.

In one implementation, the lower horizontal section includes a slope that extends down from the lower vertical section toward the inner lower radius. A thickness along a length of the lower horizontal section is uniform.

In one implementation, the lower vertical section includes one or more optical emission spectroscopy holes with probes disposed therein to monitor plasma within the plasma processing chamber for end-point detection.

In one implementation, a top surface of the upper horizontal section includes a plurality of holes configured to receive cam keys for coupling the confinement ring to corresponding cam locks disposed on a bottom surface of a backing plate disposed in the plasma processing chamber. Each one of the plurality of cam keys is disposed to align with a corresponding one of the plurality of cam locks.

In one implementation, the vertical extension is defined by an angled top section and a vertical bottom section. The angled top section is defined at an outer side adjacent to the top surface of the lower horizontal section at the inner lower radius and the vertical bottom section is defined to extend downward from a bottom portion of the angled top section at the inner lower radius.

In an alternate implementation, a confinement ring for use in a plasma processing chamber is disclosed. The confinement ring includes an upper horizontal section, an upper vertical section, a mid-section, a lower vertical section, a lower horizontal section and a vertical extension. The upper horizontal section extends between an inner upper radius and a first outer radius. The mid-section extends between the inner upper radius and a second outer radius and includes a top surface with a flat profile and a bottom surface that includes a slope that extends down from the inner upper radius toward the second outer radius. The lower horizontal section extends between an inner lower radius and the second outer radius of the confinement ring. The upper vertical section extends between the upper horizontal section and the mid-section proximate to the inner upper radius. The lower vertical section extends between the mid-section and the lower horizontal section proximate to the second outer radius. A vertical extension extends downward from the lower horizontal section proximate to the inner lower radius.

In one implementation, a top surface of the lower horizontal section is defined by a first slope that extends down from the lower vertical section toward the inner lower radius.

In one implementation, a first height defined between the bottom surface of the mid-section and the top surface of the lower horizontal section proximate to the second outer radius is less than a second height defined between the bottom surface of the mid-section and the top surface of the lower horizontal section proximate to the inner lower radius.

In one implementation, a bottom surface of the lower horizontal section is defined to include a flat profile, such that the fist slope of the lower horizontal section defines a variable thickness along a length of the lower horizontal section. The variable thickness is defined by a first thickness proximate to the second outer radius and a second thickness proximate to the inner lower radius, wherein the first thickness is greater than the second thickness.

In one implementation, a bottom surface of the lower horizontal section is defined by a second slope that extends down from the lower vertical section toward the inner lower radius. A first angle of inclination of the first slope is equal to a second angle of inclination of the second slope, so that a thickness along a length of the lower horizontal section is uniform.

In one implementation, the upper horizontal section, the upper vertical section, the mid-section, the lower vertical section, and the lower horizontal section together form a unitary S-shaped structure. The vertical extension continues the S-shaped structure downward proximate to the inner lower radius.

In one implementation, the upper horizontal section, the upper vertical section, the mid-section, and the lower vertical section define a first unitary piece and the lower horizontal section defines a second piece. The first unitary piece is configured to be received over a radio frequency gasket defined on a top surface disposed proximate to the second outer radius of the second piece.

In one implementation, the lower horizontal section includes a plurality of slots. Each slot extends radially from an inner diameter to an outer diameter along the lower horizontal section. The inner diameter of the slot is greater than an inner ring diameter of the confinement ring defined by the inner lower radius, and the outer diameter of the slot is less than an outer ring diameter of the confinement ring defined by the second outer radius. Each slot extends from a top surface to a bottom surface of the lower horizontal section.

In yet another alternate implementation, a plasma processing chamber for confining plasma within, is disclosed. The plasma processing chamber includes a lower electrode, an upper electrode structure and a confinement ring disposed between the lower electrode and the upper electrode structure. The lower electrode is disposed in a lower section (i.e., lower portion) of the plasma processing chamber and includes a support surface for supporting a substrate. The upper electrode structure is disposed in an upper section (i.e., upper portion) of the plasma processing chamber and is oriented opposite the lower electrode. The confinement ring is coupled to the upper electrode structure and is disposed between the lower electrode and the upper electrode structure. The confinement ring includes an upper horizontal section, an upper vertical section, a mid-section, a lower vertical section, a lower horizontal section and a vertical extension. The upper horizontal section extends between an inner upper radius and a first outer radius. The mid-section extends between the inner upper radius and a second outer radius. The lower horizontal section extends between an inner lower radius and the second outer radius of the confinement ring. The upper vertical section extends between the upper horizontal section and the mid-section proximate to the inner upper radius. The lower vertical section extends between the mid-section and the lower horizontal section proximate to the second outer radius. The vertical extension extends downward from the lower horizontal section proximate to the inner lower radius.

In one implementation, a plasma volume is disposed between the upper electrode, the lower electrode and the confinement ring.

In one implementation, the upper electrode structure includes an outer electrode disposed in the center of the upper electrode structure, an outer electrode that is disposed adjacent to the upper electrode, and a backing plate is disposed to surround the outer electrode. The backing plate includes an outer portion that is disposed adjacent to the outer electrode such that the outer electrode is disposed between the upper electrode and the outer portion of the backing plate, and an inner portion that is disposed over a portion of the outer electrode. A bottom surface of the outer portion of the backing plate includes a plurality of cam locks that align with corresponding keys disposed on a top surface of the upper horizontal section of the confinement ring. The cam keys and the cam locks are used to couple the outer electrode to the confinement ring.

In one implementation, the plurality of cam keys is coupled to a controller, wherein the controller is configured to generate a first signal to activate the plurality of cam keys to engage and lock with the plurality of cam locks during coupling to the backing plate and a second signal to activate the plurality of cam keys to enable unlocking of the plurality of cam locks during decoupling of the confinement ring from the backing plate. The plurality of cam locks and the plurality of cam keys are part of an electronic cam lock mechanism used for coupling the confinement ring to the upper electrode structure and is configured to be controlled by signals from the controller.

In one implementation, the backing plate and the upper electrode of the upper electrode structure are electrically grounded and the lower electrode is coupled to a radio frequency (RF) generator via a corresponding match network. The RF generator is configured to provide RF power to the lower electrode for generating plasma within the plasma processing chamber.

### DESCRIPTION OF DRAWINGS

Figure 1 illustrates a cross-sectional view of a portion of a plasma processing chamber in which a confinement ring is used, in accordance with one implementation.
Figure 2A illustrates an expanded view of an example S-shaped confinement ring disposed between an upper electrode structure and a lower electrode, in accordance with one implementation.
Figure 2B illustrates an alternate implementation of the plasma processing chamber including the S-shaped confinement ring disposed between an upper electrode structure and a lower electrode of Figure 2A, wherein in the alternate implementation includes a variation of the upper electrode structure.
Figure 3A illustrates a perspective view of a top of the S-shaped confinement ring used in the plasma processing chamber for confining plasma, in accordance with one implementation.
Figure 3B illustrates a perspective view of a bottom of the S-shaped confinement ring, in accordance with one implementation.
Figure 4 illustrates a top view of the S-shaped confinement ring showing some of the features, in accordance with one implementation.
Figure 5 illustrates a vertical cross-sectional view of a S-shaped confinement ring (cross-sectional view representing section A-A of Figure 4) illustrating additional features, in accordance with one implementation.
Figure 6A illustrates an expanded cross-sectional view of an unitary S-shaped confinement ring showing a slot at the lower horizontal section, in accordance with one implementation.
Figure 6B illustrates an alternate implementation of the S-shaped confinement ring illustrated in Figure 6A, wherein the S-shaped confinement ring is made of two pieces.
Figure 6C illustrates an expanded view of section C-C of Figure 6A, wherein the S-shaped confinement ring includes a different profile of a mid-section, in accordance with an alternate implementation of the disclosure.
Figure 6D illustrates an expanded view of section C-C of Figure 6A, wherein the S-shaped confinement ring includes a different profile of a mid-section and a lower horizontal section, in accordance with another alternate implementation of the disclosure.
Figure 7 illustrates a top view of a bottom portion of the S-shaped confinement ring with a plurality of slots (i.e., conductance slots), in accordance with one implementation.
Figure 8A illustrates an expanded view of a section H of the S-shaped confinement ring identified in Figure 7, in accordance with one implementation.
Figure 8B illustrates a magnified view of a slot included in section H of the lower horizontal section of the S-shaped confinement ring, wherein the slot is defined by a parallel slot profile, in accordance with one implementation.
Figure 8C illustrates a magnified view of a slot included in section H of the lower horizontal section of the S-shaped confinement ring, wherein the slot is defined by a tapered slot profile, in accordance with an alternate implementation.
Figure 8D illustrates a magnified view of a slot included in section H of the lower horizontal section of the S-shaped confinement ring, wherein the slot is defined with a curved slot profile, in accordance with another alternate implementation.

### DETAILED DESCRIPTION

In the various implementations described herein, a confinement ring for use in a plasma processing chamber is designed to maintain plasma uniformity in the plasma region. The confinement ring is designed to have a S-shaped configuration. The S-shape reduces the volume within the plasma region in which the plasma is contained leading to less amount of RF power needed to generate the plasma to fill the plasma region. With less volume of plasma, radial plasma density uniformity in the plasma region is improved, thereby improving the substrate radial etch uniformity. Further, the S-shaped design of the confinement ring can be used within the plasma processing chamber with the current configuration of other hardware components and does not require re-designing of other hardware components. In some implementations, the hardware components may be re-designed, although not required, to further reduce the volume of plasma maintained in the plasma region.

A plurality of slots (i.e., conductance slots) is provided at a bottom portion of the S-shaped confinement ring to efficiently remove by-products from the plasma region while optimally confining the plasma within the plasma region, resulting in improved gas conductance. The slots may be shaped to have a parallel slot profile or a tapered slot profile. The tapered slot design may be used to address the differential wear experienced along the length of the slots and to make efficient use of the area around the slot. The tapered slot profile enhances usage life of the confinement ring by ensuring optimal usage of the limited space between the slots. Consequently, the cost associated with replacing the consumable confinement ring is lowered as the number of process cycles in which the confinement ring can be used in the plasma processing chamber is extended. The S-shaped design of the confinement ring thus maintains plasma uniformity with less volume while improving density and gas conductance.

The S-shaped confinement ring used in the plasma processing chamber includes an upper horizontal section, an upper vertical section, a mid-section, a lower vertical section and a lower horizontal section. The lower horizontal section further includes a vertical extension that is used to rest the confinement ring on top of a RF gasket defined in a portion of a lower electrode. The upper horizontal section extends between a first outer radius and an inner upper radius. The mid-section extends between the inner upper radius and a second outer radius. The lower horizontal section extends between an inner lower radius and the second outer radius. The upper vertical section extends between the upper horizontal section and the mid-section proximate to the inner upper radius and the lower vertical section extends between the mid-section and the lower horizontal section proximate to the second outer radius. The vertical extension extends downward proximate to the inner lower radius and integrally continues the lower horizontal section. The upper horizontal section, the upper vertical section, the mid-section, the lower vertical section and the lower horizontal section together form an S-shaped structure that is used to reduce the amount of plasma contained in the plasma region while effectively confining the plasma generated within the plasma processing chamber.

Variations in the profile of the mid-section and, in some implementations, the lower horizontal section can also be envisioned, wherein the variations influence the amount of plasma and the density of the plasma contained in the plasma region. Like the conventional C-shaped confinement ring, the S-shaped confinement ring structure improves plasma density uniformity in the plasma region defined in the plasma processing chamber. The variation in the profile of the mid-section may be in the form of a slope along a bottom surface of the mid-section, wherein the slope extends down from the inner upper radius toward the second outer radius. The slope in the mid-section may cause a variation in the thickness along a length of the mid-section, wherein the thickness proximate to the inner upper radius is less than the thickness proximate to the second outer radius. Similarly, variation in the profile of the lower horizontal section may be in the form of a slope defined on a top surface of the lower horizontal section, wherein the slope in the lower horizontal section extends down from the second outer radius toward the inner lower radius. Additional slope may be defined in the bottom surface of the lower horizontal section so as to make the thickness of the lower horizontal section uniform along the length of the lower horizontal section.

The slope in the mid-section results in a reduction in the plasma volume within the plasma region. The reduction in the plasma volume results in less amount of gas(es) needed to form plasma for filling the plasma region. Even with the reduced volume, the S-shaped confinement ring ensures improved plasma density uniformity as well as the substrate etch uniformity in the plasma region. Further, with the S-shaped structure the mechanical strength of the confinement ring is not compromised, thereby maintaining the lifetime usage of the confinement ring. These benefits are realized without requiring changes to any hardware component (e.g., chamber spacer plate, mating hardware, etc.,) in the plasma processing chamber as the changes made to the confinement ring structure do not substantially deviate from the overall structure of conventional confinement ring.

With the aforementioned overview of the invention, specific implementations will now be described with reference to the various figures.

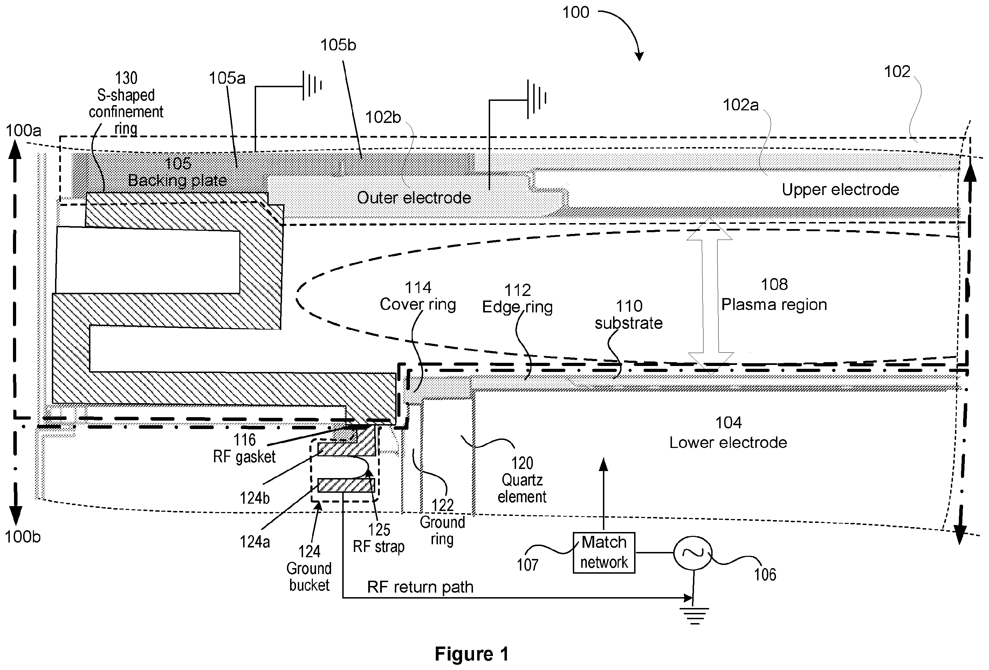

FIG. 1 illustrates a simplified block diagram of a portion of a plasma processing chamber 100 that uses an S-shaped confinement ring for confining plasma, in one implementation. The plasma processing chamber 100, in one implementation, may be a capacitively-coupled plasma (CCP) processing chamber (or simply referred to henceforth as a "plasma processing chamber"), which includes a lower electrode 104 to provide radio frequency (RF) power to the plasma processing chamber 100, and an upper electrode structure 102 to provide process gases to generate plasma within the plasma processing chamber 100. The upper electrode structure 102 is defined in the upper chamber portion 100a of the plasma processing chamber 100 and the lower electrode 104 is defined in the lower chamber portion 100b of the plasma processing chamber 100. The lower electrode 104 is connected to a RF power source 106 through a corresponding match network 107, wherein a first end of the RF power source 106 is connected to the match network 107 and a second end of the RF power source 106 is electrically grounded. The RF power source 106 may include one or more RF power generators (not shown).

In one implementation, a top surface of the lower electrode (e.g., electrostatic chuck (ESC)) 104 defines a substrate support surface on which a substrate 110 (e.g., wafer) is received for processing. In some implementation, the substrate support surface is defined in a recess defined on the top surface of the lower electrode, wherein a height of the recess is equal to the thickness of the substrate 110. An edge ring 112 is defined adjacent to the substrate support surface of the lower electrode 104 so as to surround the substrate 110, when the substrate 110 is received for processing. It is noted that throughout this application the substrate may be interchangeably referred to as a wafer and refers to a thin slice of semiconductor material (mostly made of silicon) that acts as a base on which a plurality of fabrication operations are performed to fabricate electronic integrated circuits, wherein at least one of the fabrication operations uses the plasma generated within the plasma processing chamber in which the S-shaped confinement ring is used. In some implementations, the edge ring 112 is designed such that a top surface of the edge ring 112 is co-planar with a top surface of the substrate 110, when the substrate 110 is supported on the substrate support surface of the lower electrode 104. The edge ring 112 is configured to extend the processing region for the plasma (represented by the plasma region 108) generated within the plasma processing chamber 100 to extend over an area that is beyond an edge of the substrate to an extended processing region covering an outer edge of the edge ring 112 and beyond. A cover ring 114 is disposed adjacent to the edge ring 112, such that the edge ring 112 is disposed between the cover ring 114 and the substrate 110, when the substrate is received on the substrate support surface. In some implementations, the cover ring 114 is designed such that a top surface of the cover ring 114 is co-planar with the top surface of the edge ring 112 so as to further extend the processing region from the outer edge of the edge ring 112 to an outer edge of the cover ring 114. RF power source 106 is connected to a bottom portion of the lower electrode via the match network 107 and provides RF power to the plasma processing chamber 100.

One or more insulation elements 120 are disposed below the cover ring 114 and adjacent to the lower electrode 104 so as to surround the lower electrode 104. In one implementation, the insulation elements 120 may be made of quartz material, and hence may also be referred to as quartz elements, although other insulation materials may also be employed. A ground ring 122 is disposed adjacent to the insulation element (e.g., quartz element) 120 and below the cover ring 114 such that the ground ring 122 surrounds the quartz element 120 and the lower electrode 104. A support structure in the form of a ground bucket 124 is disposed in the lower electrode 104 so as to surround a portion of the ground ring 122. In one implementation, a gap may exist between the ground ring 122 and the ground bucket 124 to provide capacitive coupling to the ground ring 122. The ground bucket 124 provides a ground return for the RF power supplied to the plasma processing chamber 100. The ground bucket 124 also provides sufficient support for a portion of the upper electrode structure 102 to rest on. For instance, a bottom portion of the S-shaped structure of the confinement ring 130 coupled to the portion of the upper electrode structure 102 rests on the ground bucket 124. In this instance, the ground bucket 124 provides an indirect support to the upper electrode structure 102 via the S-shaped confinement ring structure 130. The ground bucket 124, in one implementation, includes a fixed ring 124a at the bottom and a floating element 124b at the top. A flexible RF strap 125 is defined between the fixed ring 124a and the floating element 124b. A RF gasket 116 is disposed on a top surface of the floating element 124b of the ground bucket 124. The components of the ground bucket 124 (i.e., the fixed ring 124a, the floating element 124b and the flexible RF strap 125), in one implementation, are made of Aluminum. In other implementations, the components of the ground bucket 124 are made of any other conductive material that is suitable for conducting the RF power in the plasma processing chamber 100 to ground. In some implementation, the RF gasket 116 may be disposed within a channel defined on the top surface of the floating element 124b.

In one implementation, the upper electrode structure 102 may include an upper electrode 102a disposed in the center and an outer electrode 102b that is disposed adjacent to and surrounds the upper electrode 102a. The upper electrode 102a may be a showerhead that includes one or more inlets (not shown) connected to one or more process gas sources (not shown) and a plurality of outlets (not shown) distributed in a bottom surface of the upper electrode 102a facing the lower electrode 104. The plurality of outlets are configured to supply the process gases from the one or more process gas sources to a plasma processing region (or simply referred to as "plasma region") 108 defined between the upper electrode 102a and the lower electrode 104. The upper electrode 102a, in this implementation, is electrically grounded to provide the RF power supplied to the plasma processing chamber 100 a return path to ground. In one implementation illustrated in Figure 1, the upper electrode 102a includes an extension defined on a top surface at the outer radius. The extension is used to mate the upper electrode 102a with a corresponding lip defined on a bottom surface at an inner radius of the outer electrode 102b. In addition to the upper electrode 102a and the outer electrode 102b, the upper electrode structure 102 includes a backing plate 105. The backing plate 105 includes an outer portion 105a that surrounds the outer electrode 102b and an inner portion 105b that is disposed over and covers at least a portion of a top surface of the outer electrode 102b. The outer electrode 102b includes a plurality of fastener means (not shown) that are disposed in the portion of the top surface that is covered by the inner portion 105b of the backing plate 105 to couple the outer electrode 102b to the backing plate 105. A plurality of locking mechanism, such as cam locks (not shown), is distributed uniformly along a bottom surface of the outer portion 105a of the backing plate 105 that surrounds the outer electrode 102b. Each cam lock is designed to align with a corresponding cam key disposed on a top surface of a confinement ring structure 130 disposed below the backing plate 105 to enable the confinement ring structure 130 to couple to the backing plate 105.

In one implementation, the upper electrode structure 102 with the coupled confinement ring structure 130 is configured to move vertically up and down while the lower electrode 104 is fixed. When the plasma processing chamber 100 is to be prepared for processing, the upper electrode structure 102 with the confinement ring structure 130 is lowered to allow the confinement ring structure 130 to rest on the RF gasket 116 disposed on the top surface of the floating element 124b of the ground bucket 124. The confinement ring structure 130 pushes down on the RF gasket 116 causing the RF gasket 116 to compress to form a tight coupling between the upper electrode structure 102 and the lower electrode 104. The compression of the RF gasket 116 causes the floating element 124b to be pushed down leading to the flexible RF strap 125 to compress. When the upper electrode structure 102 is moved up, the confinement ring structure 130 moves up and away from the RF gasket 116, allowing the RF gasket 116 to relax. This causes the floating element 124b and the flexible RF strap 125 to move up from a compressed state to a relaxed state.

The confinement ring structure (or simply referred to henceforth as "confinement ring") 130 coupled to the backing plate 105 acts as a coupling interface between the upper electrode structure 102 and the lower electrode 104. The confinement ring 130 defines a confined plasma volume between the upper electrode structure and the lower electrode (102, 104) in which the plasma generated in the chamber is sufficiently contained. The plasma volume defines the plasma region 108. The confinement ring 130 is an S-shaped structure with an opening at the lower portion of the S-shape facing an inside of the plasma region 108. Figure 1 illustrates an example of a left-hand portion of the plasma processing chamber having the S-shaped confinement ring structure with the opening in the lower portion of the inverted S-shaped confinement ring 130 facing the inside of the plasma region 108, wherein the plasma region 108 extends over the surfaces of the substrate 110, edge ring 112 and the cover ring 114 disposed on the lower electrode 104 of the plasma processing chamber 100. A plurality of keys of the locking mechanism, such as cam keys, is defined on a top surface of the confinement ring 130. The cam keys are configured to couple with corresponding cam locks disposed on the bottom surface of the outer portion 105a of the backing plate 105. The confinement ring 130 is part of the upper electrode structure 102 and a bottom section of the confinement ring 130 is configured to rest on the RF gasket 116 defined on a top surface of the ground bucket 124 defined in the lower electrode 104. The RF gasket 116 ensures that the coupling between the upper and the lower electrodes 102, 104, is air-tight. In one implementation, the ground bucket 124 is configured to surround a region of the lower electrode 104 that includes at least the substrate support 110, the edge ring 112, the cover ring 114, the one or more quartz elements 120, and the ground ring 122. The ground bucket 124 provides a return path to ground for the RF current provided by the RF power source 106 to the lower electrode 104.

It is to be noted that the plasma processing chamber of Figure 1 is shown to include only specific parts described herein, whereas in reality the plasma processing chamber includes a plurality of additional components that are needed for processing substrate. For example, a lift pin mechanism with lift pins to lift or lower the substrate 110, is not shown. Further, the various components shown in Figure 1 may not be to scale and/or may be exaggerated in order to identify the different features of the various components.

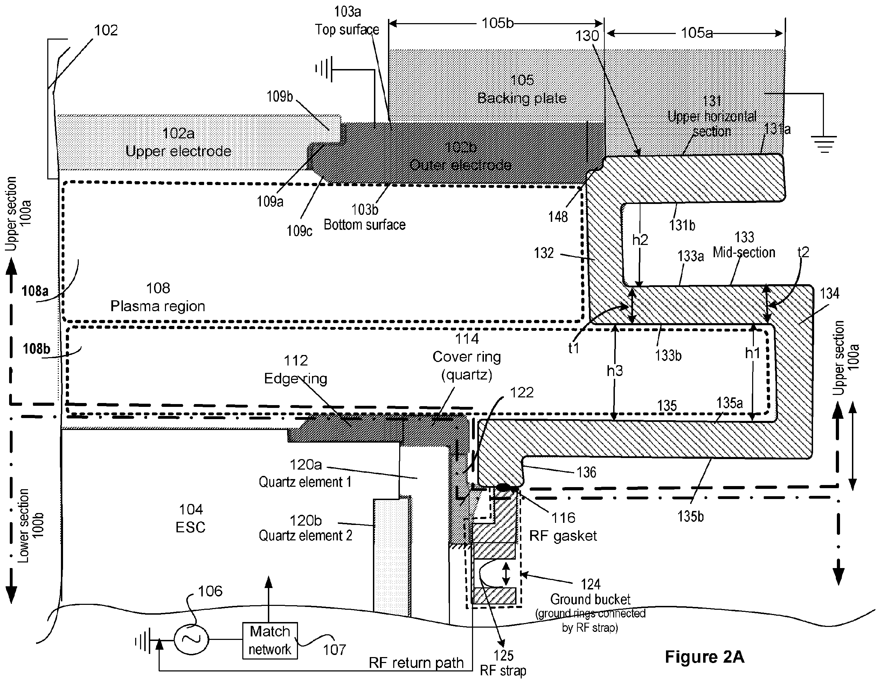

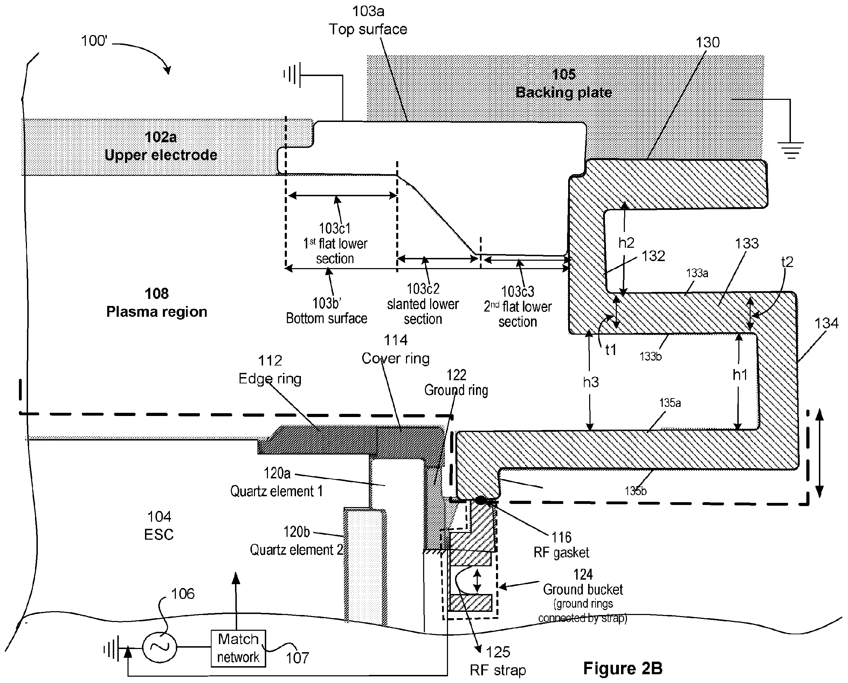

The confinement ring 130, broadly speaking, is defined by a plurality of components, including an upper horizontal section, an upper vertical section, a mid-section, a lower vertical section, a lower horizontal section and a vertical extension. A plurality of cam locks are distributed on a top surface of the upper horizontal section and are used for coupling the confinement ring 130 to the outer portion 105a of the backing plate 105 of the upper electrode structure 102, wherein the upper electrode structure 102 includes the upper electrode 102a, the outer electrode 102b and the backing plate 105. The upper vertical section of the S-shaped confinement ring 130 acts to reduce the plasma volume within the plasma region 108 for receiving the plasma. The reduction in the plasma volume is done without adversely affecting the density of the plasma or the plasma distribution in the plasma region 108. Details of the various components of the confinement ring 130 will be described in greater detail with reference to Figures 2A and 2B.

FIG. 2A illustrates an expanded cross-sectional view of the plasma processing chamber 100 in which the S-shaped confinement ring 130 is disposed to confine the plasma in the plasma region 108, in one implementation. As noted with reference to Figure 1, the plasma processing chamber 100 includes an upper chamber portion 100a in which an upper electrode structure 102 is disposed, and a lower chamber portion 100b in which a lower electrode 104 is disposed. The upper electrode structure 102 includes a plurality of components including an upper electrode 102a, an outer electrode 102b and a backing plate 105. The upper electrode 102a is disposed in the center to substantially cover a region over a substrate support surface on which a substrate 110 is received for processing. The outer electrode 102b is disposed adjacent to and surrounds the upper electrode 102a. The outer electrode 102b includes a top surface and a bottom surface. The top and the bottom surfaces of the outer electrode 102b, in this implementation, have a flat profile. The outer electrode 102b is electrically grounded. The backing plate 105 includes an outer portion 105a that is disposed adjacent to and surrounds the outer electrode 102b, and an inner portion 105b that is disposed over a portion of the outer electrode 102b, wherein the portion of the outer electrode 102b is less than or equal to a whole of the outer electrode 102b. The backing plate 105 is also electrically grounded.

In one implementation, an S-shaped confinement ring 130 is coupled to the outer portion 105a of the backing plate 105 using a fastening mechanism (e.g., cam lock structure) (not shown). The cam lock structure, for example, includes one or more cam locks that can be operated using corresponding one or more cam keys. In this implementation, a plurality of cam locks (not shown) is distributed uniformly across a bottom surface of the outer portion 105a of the backing plate 105. The cam locks may be disposed such that each cam lock aligns with a corresponding cam key (not shown) provided on a top surface of the S-shaped confinement ring 130 that is disposed below the outer portion 105a of the backing plate 105. In one implementation, the cam lock structure is an electronic cam lock structure, wherein the cam keys disposed on the top surface of the confinement ring 130 are coupled to a controller and operated using signals from the controller (not shown). The controller may be coupled to the plasma processing chamber 100 and used to control process parameters of the plasma processing chamber 100. For example, the controller may be used to control the process recipe of process gas(es) used in the plasma processing chamber 100, the RF power provided to the plasma processing chamber, the exposure time of the substrate 110 to the plasma, the concentration of gas(es) used in the plasma processing chamber, etc. The controller may be coupled to a computer or may be part of a computer that is used to provide the process recipes for generating the plasma in the plasma processing chamber 100. In addition to controlling the various process parameters, the controller may also be used to provide appropriate signals to the cam keys for locking with the cam locks. For instance, in one implementation, the controller may be used to generate a first signal to activate the plurality of cam keys to engage and lock into the cam locks, when the confinement ring 130 needs to be coupled to the outer portion 105a of the backing plate 105. Similarly, the controller may be used to generate a second signal to the cam keys to unlock the cam keys from the cam locks, when the confinement ring 130 is to be de-coupled from the backing plate 105. In some implementations, the first signal for locking may be generated upon detecting a new confinement ring 130 being installed in the plasma processing chamber 100. In some implementations, the second signal for unlocking may be generated when an existing confinement ring 130 has to be removed, for example, after reaching the end of usage life of the confinement ring 130. The implementations are not restricted to the electronic cam lock structure. Instead, other types of cam locks or other types of locking mechanism (e.g., threaded screws, etc.,) may be used to couple the confinement ring 130 to the backing plate 105.

In the implementation illustrated in Figure 2A, a bottom surface 103b of the outer electrode 102b facing the plasma region 108 is defined to be flat. In one implementation, an inner side of the outer electrode 102b that is disposed adjacent to the upper electrode 102a includes a step 109a defined on a top surface. The step 109a may be used to receive a corresponding lip extension 109b defined on a top surface at the outer radius of the upper electrode 102a. The step 109a offers a reliable mating surface for receiving the upper electrode 102a. In addition to the step 109a, a bottom surface at an inner edge of the outer electrode 102b may include a slanted surface 109c, in one implementation. The slanted surface 109c may be designed so as to allow unrestricted flow of the plasma in the plasma region 108. When any portion of the plasma region 108 has a sharp edge, the plasma flow may be hindered by the angle of the sharp edge. Thus, in order to avoid such hindrance to the plasma flow, the inner edge on the bottom surface of the outer electrode 102b is angled down and away from the bottom outer edge of the upper electrode 102a toward the outer edge of the outer electrode 102b. The angle of slope of the slanted surface 109c at the inner edge and a length of the slanted surface 109c may be defined to ensure optimal plasma flow in the plasma region 108. In alternate implementations, instead of a slanted surface 109c, the inner edge on the bottom surface of the outer electrode 102b may include a rounded edge. The various components of the plasma processing chamber 100 that are common between Figures 1 and 2A are represented using the same reference numerals and perform the same function.

In one implementation, the quartz element 120 in the lower electrode 104 of Figure 1 may be made of two or more parts. In the implementation illustrated in Figure 2A, the quartz element 120 includes two quartz elements - quartz element 1 120a that is disposed below the cover ring 114 and adjacent to the ground ring 122, such that a portion of the quartz element 1 120a is disposed to surround a first portion of the lower electrode 104 and is between the lower electrode 104 and the ground ring 122. Adjacent to a portion of the quartz element 1 120a and between a second portion of the lower electrode 104 and the quartz element 1 120a, a second quartz element 2 120b is disposed. The first portion of the lower electrode 104 is defined above the second portion of the lower electrode 104. Additional quartz elements may be disposed in the lower electrode 104 adjacent to the ground ring 122, ground bucket 124. The edge ring 112 defined in the lower electrode 104 may include a step at an inner side that is adjacent to the substrate support surface of the lower electrode 104. A wall of the step may be defined by a straight edge or a sloped edge. The step of the edge ring 112 may be defined by a height that is equal to a thickness of the substrate 110 received on the substrate support surface of the lower electrode 104 so that when the substrate 110 is received on the substrate support surface, a top surface of the substrate 110 is co-planar with a top surface of the edge ring 112. Similarly, thickness of the cover ring 114 may be defined to be equal to a thickness of the edge ring 112 at the outer edge of the edge ring 112, so that a top surface of the cover ring 114 is co-planar with the top surface of the edge ring 112. The thickness of the edge ring 112 and the cover ring 114 are defined based on the substrate support surface of the lower electrode 104 on which the edge ring and the cover ring are disposed. When the substrate support surface has a different profile, then the thickness of the edge ring 112 and the cover ring 114 may be defined in accordance to the different profile so that the top surfaces of the edge ring 112 and the cover ring 114 are co-planar with the top surface of the substrate 110 received thereon. The S-shaped confinement ring 130 is disposed between the upper electrode structure 102 and the lower electrode 104. The upper section 100a of the plasma processing chamber 100 that includes the upper electrode structure 102 and the confinement ring 130 can be moved together vertically up and down as shown by dashed lines in Figure 2A.

The S-shaped confinement ring 130 includes an upper horizontal section 131, an upper vertical section 132, a mid-section 133, a lower vertical section 134, and a lower horizontal section 135. A vertical extension 136 extends down from the lower horizontal section 135 proximate to the inner lower radius. The upper horizontal section 131 extends between an inner upper radius and a first outer radius of the confinement ring 130. In one implementation, a top surface of the upper horizontal section at the inner upper radius includes a step 148 on which a lip extension defined at the outer edge of the bottom surface of the outer electrode 102b is received. The height of the step 148 is defined to provide a reliable mating surface for receiving and supporting the outer electrode 102b. The upper horizontal section 131 is defined by a top surface 131a and a bottom surface 131b. The top surface 131a of the upper horizontal section 131 is defined to be flat and includes a plurality of cam keys (not shown) defined to align with corresponding cam locks (not shown) defined on a bottom surface in the outer portion 105a of the backing plate 105. The cam locks are used to keep the confinement ring 130 in place, when the confinement ring 130 is coupled to the backing plate 105. The bottom surface 131b of the upper horizontal section 131 is defined to be flat such that a thickness along a length of the upper horizontal section 131 is uniform.

The mid-section 133 extends between the inner upper radius and a second outer radius of the confinement ring 130. The mid-section is also defined by a top surface 133a and a bottom surface 133b. In one implementation illustrated in Figure 2A, the top surface 133a and the bottom surface 133b of the mid-section 133 are defined to be flat (i.e., horizontal), such that a thickness 't1' of the mid-section 133 proximate to the inner upper radius is equal to thickness 't2' of the mid-section 133 proximate to the second outer radius. The upper vertical section 132 extends between the upper horizontal section 131 and the mid-section 133 proximate to the inner upper radius. In one implementation, the proximity to the inner upper radius is defined to be offset from a junction of the upper vertical section 132 and the mid-section 133, wherein the offset is defined by a thickness of the upper vertical section 132. In alternate implementation, the proximity to the inner upper radius is defined to be in-between the inner upper radius and an outer side (i.e., the side that faces away from the plasma region) of the upper vertical section 132. The upper vertical section 132 extends for a height 'h2'. In the implementation illustrated in Figure 2A, an inner side of the upper vertical section 132 facing the plasma region 108 and the outer side of the upper vertical section 132 facing away from the plasma region 108 are defined to be vertical, and the distance between the inner side and the outer side of the upper vertical section 132 defines the thickness of the upper vertical section 132. In alternate implementation, the inner side of the upper vertical section 132 may include a curved or bowed profile. In this implementation, the thickness of the upper vertical section 132 varies along the length of the upper vertical section 132 due to the curved or bowed profile.

The lower horizontal section 135 is defined to extend from an inner lower radius to the second outer radius. The lower horizontal section 135 is defined by a top surface 135a and a bottom surface 135b. In the implementation illustrated in Figure 2A, both the top surface 135a and the bottom surface 135b of the lower horizontal section 135 is defined to be flat (i.e., horizontal). In one alternate implementation, the top surface 135a may include a slope that slopes down from the second outer radius toward the inner lower radius. In another alternate implementation, both the top and the bottom surfaces 135a, 135b of the lower horizontal section 135 may include a slope that slopes down from the second outer radius toward the inner lower radius. The angle of the slope of both the top and the bottom surfaces 135a, 135b, of the lower horizontal section, in this implementation, may be equal. In an alternate implementation, the angle of slope of the top surface 135a may be different from the angle of slope of the bottom surface 135b.

The lower vertical section 134 extends between the mid-section 133 and the lower horizontal section 135 proximate to the second outer radius. The lower vertical section extends for a height 'h1' proximate to the second outer radius and a height 'h3' proximate to the inner upper radius. In the implementation illustrated in Figure 2A where the top and the bottom surfaces (133a, 133b) of the mid-section 133 are flat (i.e., the thickness t1 of the mid-section 133 at the inner upper radius is equal to the thickness t2 at the second outer radius), and the top and the bottom surfaces (135a, 135b) of the lower horizontal section 135 are flat (i.e., the thickness of the lower horizontal section 135 is uniform along the length of the lower horizontal section 135), the height h1 proximate to the second outer radius is equal to the height h3 proximate to the inner upper radius. Further, in one implementation, the height h1 of the lower vertical section 134 at the second outer radius may be equal to height h2 of the upper vertical section 132 proximate to the inner upper radius. In alternate implementations, the height h2 may be greater than or less than height h1. The height h2 changes the volume of plasma within the plasma region 108. When a slope is defined at the bottom surface 133b of the mid-section 133 and/or a slope is defined at the top surface 135a of the lower horizontal section 135, the height h1 proximate to the second outer radius may be less than height h3 proximate to the inner upper radius.

The plasma region 108 is defined between the upper electrode structure 102, the lower electrode 104 and the confinement ring 130. The plasma region 108 defines a plasma volume into which the plasma generated in the plasma processing chamber 100 is received. The plasma volume in the plasma region 108 includes an external volume 108a and an internal volume 108b. The external volume 108a is defined between the upper horizontal section 131, the upper vertical section 132 and the mid-section 133. The external volume 108a is defined in the area immediately below the upper electrode 102a and the outer electrode 102b and outside (i.e., on top of or above) the internal volume 108b in the plasma region 108. The external volume 108a reduces the overall volume of plasma in the plasma region 108. In one implementation, the amount of plasma volume in the plasma region 108 reduced by the external volume 108a is driven by the length of the mid-section 133, the height h2 of upper vertical section 132 and by, to some extent, the thickness of the mid-section 133. The internal volume 108b is defined between the mid-section 133, the lower vertical section 134 and the lower horizontal section 135. The internal volume 108b is defined to be inside the plasma volume and is between the external volume 108a in the top and the substrate support surface of the lower electrode 104. The amount of plasma that can be accommodated in the internal volume 108b depends on the length of the mid-section 133, the height h1 of the lower vertical section 134 and the length of the lower horizontal section 135.

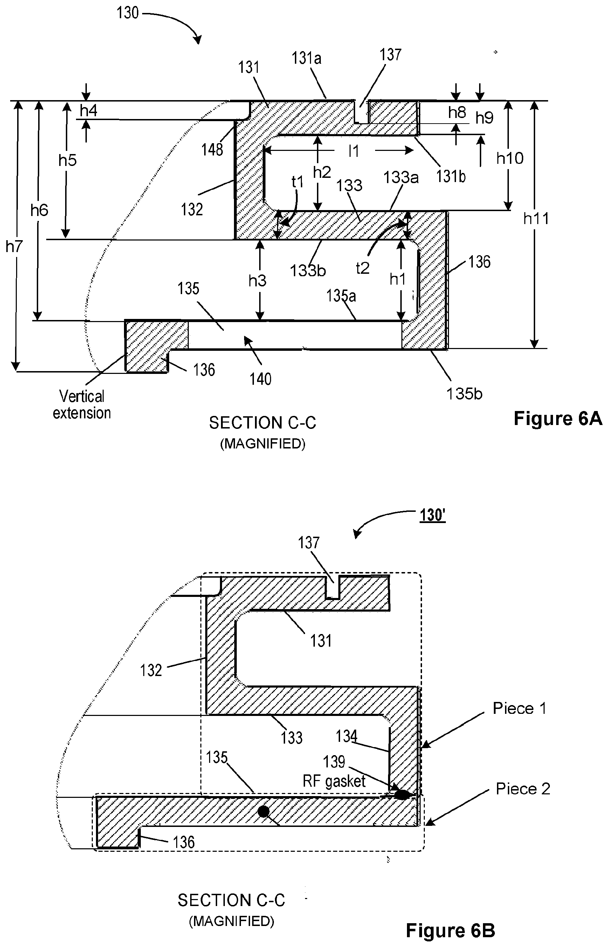

The vertical extension 136 is defined to extend down from the lower horizontal section 135 proximate to the inner lower radius and integrally continue the lower horizontal section 135 downward for a height. In some implementations, the vertical extension 136 is used during coupling of the upper electrode structure 102 to the lower electrode 104. For example, when the plasma processing chamber 100 is being prepared for processing, the upper electrode structure 102 is brought down so that the vertical extension 136 of the S-shaped confinement ring 130 rests on the RF gasket 116 disposed on the top surface of the ground bucket 124 defined in the lower electrode 104. In one implementation, the upper horizontal section 131, the upper vertical section 132, the mid-section 133, the lower vertical section 134, and the lower horizontal section 135 together form a unitary S-shaped confinement ring 130. The vertical extension 136 defined proximate to the inner lower radius extends the lower horizontal section 135 downward. In alternate implementations, the S-shaped confinement ring 130 may be made of a plurality of pieces, as will be described with reference to Figure 6B.

Figure 2B illustrates an alternate implementation of a plasma processing chamber 100' in which an S-shaped confinement ring 130 is disposed. The various components that are common between the plasma processing chamber 100 of Figure 2A and the plasma processing chamber 100' of Figure 2B are represented using same reference numerals and perform similar function. Figure 2B illustrates an alternate structure of the outer electrode 102b', wherein a bottom surface of the outer electrode 102b' includes a sloped profile. Although not required to re-design other hardware components within the plasma processing chamber 100 to accommodate the S-shaped confinement ring 130, some of the hardware components may be re-designed, in some implementations, and such re-designing may be done to further reduce the volume within the plasma region 108 for receiving the plasma. In the implementation illustrated in Figure 2B, the outer electrode 102b' includes a top surface 103a and a bottom surface 103b'. The top surface 103a is flat and the bottom surface 103b' is defined by a slope in at least a portion of the bottom surface 103b', wherein the portion that includes the slope may be the whole or less than the whole portion of the bottom surface 103b'. In the implementation illustrated in Figure 2B, for example, the bottom surface 103b' is defined by a first flat lower section 103c1, a slanted lower section 103c2, and a second flat lower section 103c3. The first flat lower section 103c1 is defined at an inner side that is disposed adjacent to the upper electrode 102a, and extends for a first length.

In one implementation, the first flat lower section 103c1 may include an angled or rounded inner edge defined adjacent to the upper electrode 102a. The slanted lower section 103c2 is disposed adjacent to the first flat lower section 103c1, and extends for a second length. The second flat lower section 103c3 is disposed adjacent to the slanted lower section 103c2 such that the slanted lower section 103c2 is defined between the first flat lower section 103c1 and the second flat lower section 103c3. The second flat lower section 103c3 extends to the outer edge of the outer electrode 102b' and covers a third length. The slanted lower section 103c2 includes a slope that extends down from the first flat lower section 103c1 toward the second flat lower section 103c3. In one implementation, an angle of the slope of the slanted lower section 103c2 and an angle of the angled inner edge (if any) of the outer electrode 102b' may be defined to allow the plasma to flow freely within the plasma region 108. The angle of the slanted lower section 103c2 causes a variance in the height at the inner side and the outer side of the outer electrode 102b', wherein a height of the inner side of the outer electrode 102b' is less than a height of the outer side of the outer electrode 102b'. Consequently, the outer side of the outer electrode 102b' that is adjacent to the inner side of the upper vertical portion 132 covers a portion of the upper vertical section 132 of the S-shaped confinement ring 130. The variance in the height of the inner side to the outer side of the outer electrode 102b' depends on the angle of the slope of the slanted lower section 103c2. In one implementation, the length of each of the sections - first flat lower section 103c1, the slanted lower section 103c2, and the second flat lower section 103c3, are equal. In alternate implementations, the length of each of the sections is different. For example, the length of the first and the second flat lower sections 103c1, 103c3, may be equal while the length of the slanted lower section 103c2 may be lesser than or greater than the length of the first and the second flat lower sections 103c1, 103c3. The slanted lower section 103c2 reduces the volume within the plasma region 108 further. As a result, lesser volume of plasma is needed within the plasma region 108 for performing the fabrication operation. Even with lesser volume, the density of the plasma is improved due to more plasma contained within the smaller internal volume of the plasma region 108 and the plasma uniformity and the gas conductance are maintained at the optimal level in the plasma volume of the plasma region 108.

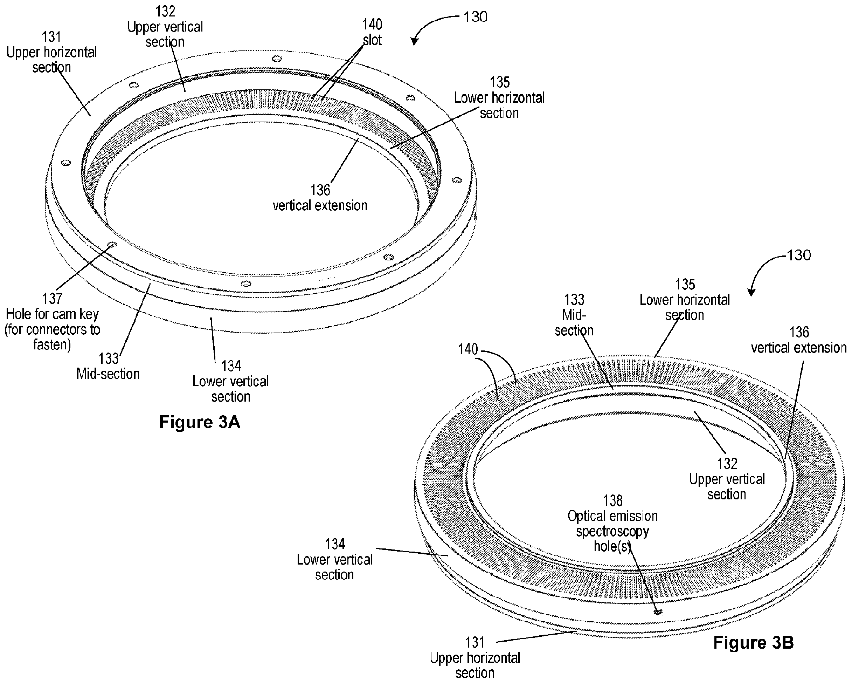

Figure 3A illustrates a perspective view of a top side of the S-shaped confinement ring 130 used in the plasma processing chamber 100 and Figure 3B illustrates a perspective view of a bottom side of the S-shaped confinement ring 130, in one implementation. Referring first to Figure 3A, the S-shaped confinement ring 130 includes the upper horizontal section 131 on which a plurality of holes 137 are defined, wherein each hole is configured to receive a portion of a fastening mechanism, such as a cam key. The fastening mechanism is not restricted to the cam lock structure but can include other fastening mechanisms, such as threaded screws, etc. In some implementations, the holes 137 for receiving the plurality of cam keys are uniformly distributed on the top surface 131a, wherein the cam keys are used for coupling the confinement ring 130 to the upper electrode structure 102 via the corresponding cam locks defined on the bottom surface of the backing plate 105. The upper horizontal section 131 extends between a first outer radius and a top of an upper vertical section 132 defined at or proximate to an inner upper radius of the confinement ring 130. The upper vertical section 132 extends between the upper horizontal section 131 and the mid-section 133. The mid-section 133 extends between a bottom of the upper vertical section 132 and a top of a lower vertical section 134 defined at or proximate to a second outer radius. The lower horizontal section 135 extends between a bottom of the lower vertical section 134 and the inner lower radius. The lower horizontal section includes a plurality of conductance slots (or simply referred to henceforth as "slots") 140. The slots 140 extend radially on the surface of the lower horizontal section 135 from an inner diameter to an outer diameter. The inner diameter of the slots 140 is greater than the inner ring diameter of the confinement ring 130, wherein the inner ring diameter is defined by the inner lower radius. The outer diameter of the slots is greater than the inner ring diameter and the inner diameter but is less than the outer ring diameter of the confinement ring 130, wherein the outer ring diameter is defined by the second outer radius. In the implementation illustrated in Figures 2A, 2B, 3A and 3B, the first outer radius is less than the second outer radius. In alternate implementations, the first outer radius may be equal to or greater than the second outer radius. In the implementation illustrated in Figure 3A, the upper horizontal section 131, the upper vertical section 132, the mid-section 133, the lower vertical section 134, and the lower horizontal section 135 of the confinement ring 130 together form a unitary structure (i.e., a single contiguous unit).

Figure 3B illustrates a plurality of slots 140 defined in the lower horizontal section 135. In the implementation illustrated in Figure 3B, the slots 140 are defined to include parallel slot geometry. In alternate implementations, the slots 140 may be defined to include tapered slot geometry, wherein the tapered slot is defined by a broad side defined at the outer diameter and a narrow side defined at the inner diameter of the confinement ring 130. The broad side of the slot is defined by an outer slot radius that is greater than the narrow side that is defined by the inner slot radius. The size of the inner slot radius and the outer slot radius are defined to be an inverse of a wear rate at the corresponding inner and outer diameters of the slots 140. In one implementation, one or more optical emission spectroscopy (OES) holes 138 are defined on the lower vertical section 134. The OES holes 138 are equipped with probes that are used to monitor the plasma in the plasma region 108 and the effect of the plasma on the top surface of the substrate 110. Results from the probes disposed in the OES holes 138 are used for end-point detection.

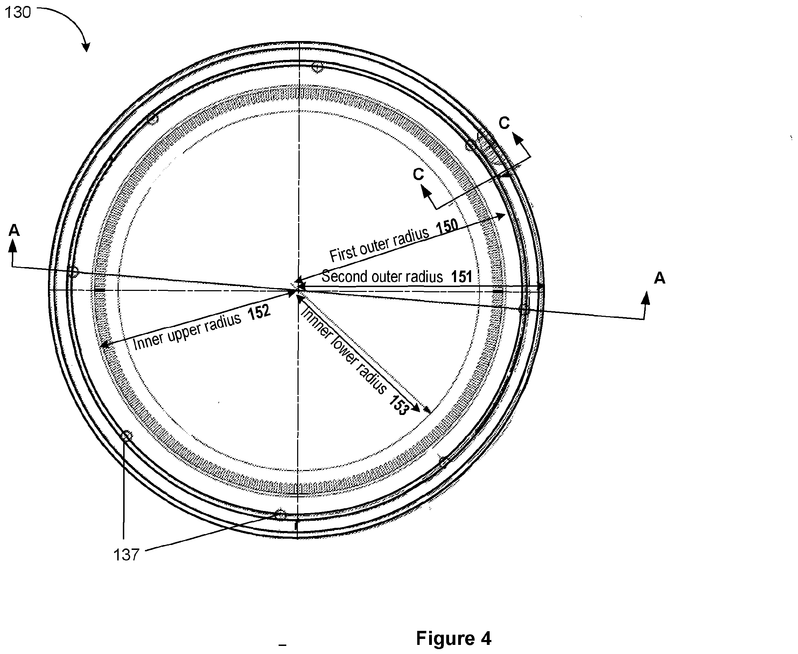

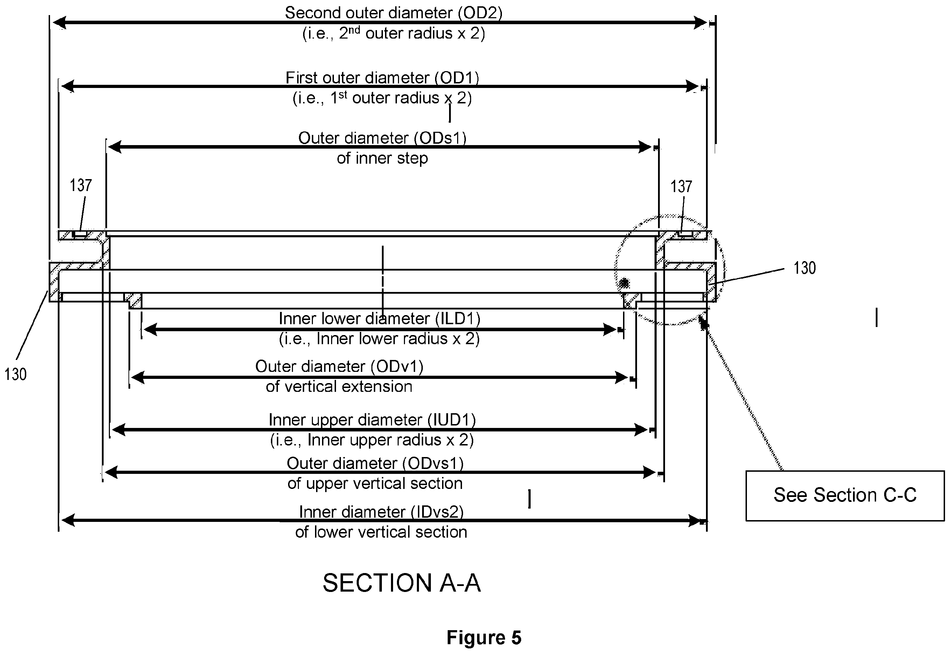

Figure 4 illustrates an overhead view of a top side of the S-shaped confinement ring 130 used in the plasma processing chamber, in one implementation. Figure 4 identifies some of the features of the confinement ring 130. For example, as shown, the upper horizontal section 131 extends from the first outer radius 150 to the inner upper radius 152. The lower horizontal section 135 extends from a second outer radius 151 to an inner lower radius 153. The second outer radius 151 is greater than the first outer radius 150, and the inner lower radius 153 is smaller than the inner upper radius 152 (i.e., the inner lower radius 153 < the inner upper radius 152 < the first outer radius 150 < the second outer radius 151). The inner lower radius 153 defines the inner ring diameter of the confinement ring 130, and the second outer radius 151 defines the outer ring diameter of the confinement ring 130. Figure 4 shows the plurality of holes 137 for receiving the cam keys (i.e., part of the locking mechanism) distributed on the top surface of the upper horizontal section 131. In some implementation, the upper horizontal section 131 overhangs over a portion of the mid-section 133 and the mid-section 133 overhangs over a portion of the lower horizontal section 135 that includes the slots 140. Figure 4 shows the relative overhang of the upper horizontal section 131 and the mid-section 133. A cross-sectional view of section A-A of Figure 4 is shown and explained in detail with reference to Figure 5 and a cross-sectional view of section C-C of Figure 4 is shown and explained in detail with reference to Figures 6A - 6D.

Figure 5 illustrates a cross-sectional view of section A-A identified in Figure 4, in one implementation. The cross-sectional view identifies the various features of the S-shaped confinement ring 130. In some implementations, the inner upper diameter (IUD1) defined by the inner upper radius of the upper horizontal section 131 is defined to be between about 420 mm (about 16.54 inches) and about 432 mm (about 17.01 inches). In some implementations, the first outer diameter (OD1) defined by the first outer radius to which the upper horizontal section 131 extends to is defined to be between about 500 mm (about 19.7 inches) and about 516 mm (about 20.3 inches). In some implementations, the second outer diameter (OD2) to which the mid-section 133 extends is defined to be between about 510 mm (about 20.08 inches) and about 530 mm (about 20.87 inches). In some implementations, the outer diameter (ODs1) of the step 148 defined in the upper horizontal section 131 of the confinement ring 130 is defined to be between about 426 mm (about 16.77 inches) and about 438 mm (about 17.24 inches). In some implementations, the inner diameter of the inner side of the upper vertical section 132 is defined to be the same as the inner upper diameter of the upper horizontal section 131. In some implementations, the outer diameter (ODvs1) of the upper vertical section 132 is defined to be between about 430 mm (about 16.93 inches) and about 448 mm (about 17.64 inches). In some implementations, the thickness of the upper vertical section 132 is defined to be between about 10 mm (about 0.39 inches) and about 16 mm (about 0.63 inches). In some implementations, the inner diameter (IDvs2) of the lower vertical section 134 is defined to be between about 500 mm (about 19.69 inches) and about 516 mm (about 20.32 inches), and the outer diameter of the lower vertical section 134 is defined by the second outer diameter (OD2). In some implementations, the thickness of the lower vertical section 134 is defined to be between about 10 mm (about 0.39 inches) and about 14 mm (about 0.55 inches). In some implementations, the inner lower diameter (ILD1) (i.e., same as inner lower radius x 2) to which the lower horizontal section 135 extends to is defined to be between about 370 mm (about 14.57 inches) and about 385 mm (about 15.16 inches). The aforementioned range for the various features of the S-shaped confinement ring 130 has been provided as mere examples and should not be considered restrictive. Other ranges or adjustment to aforementioned ranges for the various features may be envisioned and such ranges or adjustments may be based on the inner dimensions of the plasma processing chamber 100, type of process that is being performed, type of process gases used to generate the plasma, amount of area desired within internal volume of the plasma region for the plasma, type of by-products and neutral gas species that are generated and are to be removed, access openings of the plasma processing chamber, geometry of hardware components of the plasma processing chamber, etc. In the illustration of Figure 5, the S-shaped confinement ring 130 is shown to have mid-section and the lower horizontal section with flat profile.

Figure 6A illustrates a magnified cross-sectional view of the S-shaped confinement ring 130, in one implementation. The cross-sectional view is taken where a slot 140 is disposed at the lower horizontal section 135. The cross-sectional view identifies the height of the different components of the confinement ring 130. For example, a height h1 is defined between a top surface 135a of the lower horizontal section 135 and a bottom surface 133b of the mid-section 133 proximate to the second outer radius of the confinement ring 130. In one implementation, the height h1 is defined to be between about 10 mm (about 0.39 inches) and about 40 mm (about 1.57 inches). A height h2 is defined between a top surface 133a of the mid-section 133 and a bottom surface 131b of the upper horizontal section 131. In one implementation, the height h2 is defined to be between about 10 mm (about 0.39 inches) and about 40 mm (about 1.57 inches). A height h3 is defined between the top surface 135a of the lower horizontal section 135 and the bottom surface 133b of the mid-section 133 proximate to the inner upper radius of the confinement ring 130. In one implementation where the lower horizontal section 135 is flat, the height h3 is defined to be equal to height h1. In alternate implementations where the lower horizontal section 135 has a sloped top surface 135a, the height h3 may be greater than height h1. A step 148 defined at the top surface of the upper horizontal section at the inner upper radius has a height h4. In one implementation, the height h4 is defined to be between about 3.8 mm (about 0.15 inches) and about 4.5 mm (about 0.18 inches). The upper vertical section 132 of the S-shaped confinement ring 130 is defined to extend for a height h5. In one implementation, the height h5 is defined to be between about 28 mm (about 1.10 inches) and about 34 mm (about 1.34 inches). A height h6 is defined between the top surface 131a of the upper horizontal section 131 and a top surface 135a of the lower horizontal section 135. In one implementation, the height h6 is defined to be between about 45 mm (about 1.77 inches) and about 53 mm (about 2.09 inches). A height h7 is defined between the top surface 131a of the upper horizontal section 131 and a bottom surface of the vertical extension 136. In one implementation, the height h7 is defined to be between about 56 mm (about 2.20 inches) and about 65 mm (about 2.56 inches). A height h8 is defined for a hole 137 defined on the top surface 131a of the upper horizontal section 131 into which a portion of the locking mechanism, such as a cam key, can be disposed. In one implementation, the height h8 is defined to be between about 4.6 mm (about 0.18 inches) and about 5.4 mm (about 0.21 inches). A thickness of the upper horizontal section 131 is defined by height h9. In one implementation, the height h9 is defined to be between about 7.4 mm (about 0.29 inches) and about 8.25 mm (about 0.32 inches). A height h10 is defined between the top surface 131a of the upper horizontal section 131 and a top surface 133a of the mid-section. In one implementation, the height h10 is defined to be between about 21 mm (about 0.83 inches) and about 29 mm (about 1.14 inches). A height h11 is defined between the top surface 131a of the upper horizontal section 131 and a bottom surface 135b of the lower horizontal section 135. In one implementation, the height h11 is defined to be between about 50 mm (about 1.97 inches) and about 60 mm (about 2.36 inches). In the implementation illustrated in Figure 6A, the top surface 133a and the bottom surface 133b of the mid-section 133 is defined to be flat. Consequently, the thickness t1 of the mid-section 133 proximate to the inner upper radius is equal to thickness t2 of the mid-section 133 proximate to the second outer radius (i.e., the mid-section has uniform thickness along its length). In this case, the thickness t1 and t2 are defined to be between about 12 mm (about 0.47 inches) and about 20 mm (about 0.79 inches), according to some implementations. The upper horizontal section 131 extends out for a length 11 from the outer side of the upper vertical section 132. In one implementation, the length 11 is defined to be between about 29 mm (about 1.14 inches) and about 38 mm (about 1.50 inches). In one implementation, the vertical extension 136 extends down from a bottom surface 135b of the lower horizontal section 135 by about 3 mm (about 0.12 inches) to about 7 mm (about 0.28 inches). The S-shaped confinement ring 130 illustrated in Figure 6A is a unitary piece, wherein the upper horizontal section 131, the upper vertical section 132, the mid-section 133, the lower vertical section 134, and the lower horizontal section 135 together form a single, contiguous piece. The vertical extension 136 extends down from the lower horizontal section 135 proximate to the inner lower radius. The aforementioned ranges for the various components of the S-shaped confinement ring 130 have been provided as mere examples and should not be considered restrictive. Other ranges or adjustment to aforementioned ranges for the various components may also be envisioned.

Figure 6B illustrates an alternate implementation of the S-shaped confinement ring 130 of Figure 6A. In the implementation illustrated in Figure 6B, the S-shaped confinement ring 130' is made of two pieces. The lower horizontal section 135 of the S-shaped confinement ring 130 that includes the slots 140 is a highly consumable part (i.e., has smaller usage life) as it is exposed to the plasma and the by-products, while the remaining sections of the S-shaped confinement ring 130 may last longer (i.e., greater usage life) than the lower horizontal section 135. Thus, in order to maximize usage life of the confinement ring, the confinement ring 130' may be designed to be made of two pieces. For example, the upper horizontal section 131, the upper vertical section 132, the mid-section 133 and the lower vertical section 134 together define a single unitary first piece (i.e., piece 1), and the lower horizontal section 135 and the vertical extension 136 define the second piece (i.e., piece 2). The first piece may be received over a RF gasket 139 disposed on the top surface 135a of the lower horizontal section 135 of the second piece proximate to the second outer radius. The RF gasket 139 provides a tight coupling of the two pieces, when the two pieces are assembled together within the plasma processing chamber 100, and provides a path for the RF current to ground (similar to RF gasket 116 defined over a top surface of the floating element 124b of the ground bucket 124 disposed in the lower electrode 104). In the implementation illustrated in Figure 6B, the height h1 between the bottom surface 133b of the mid-section 133 and the top surface 135a of the lower horizontal section 135 proximate to the second outer radius may be varied by including a slope in the bottom portion 133a of the mid-section 133. In other alternate implementations, the S-shaped confinement ring 130 may be made up of more than two pieces, with each piece connecting to the following piece via a RF gasket disposed on the following piece, for example.

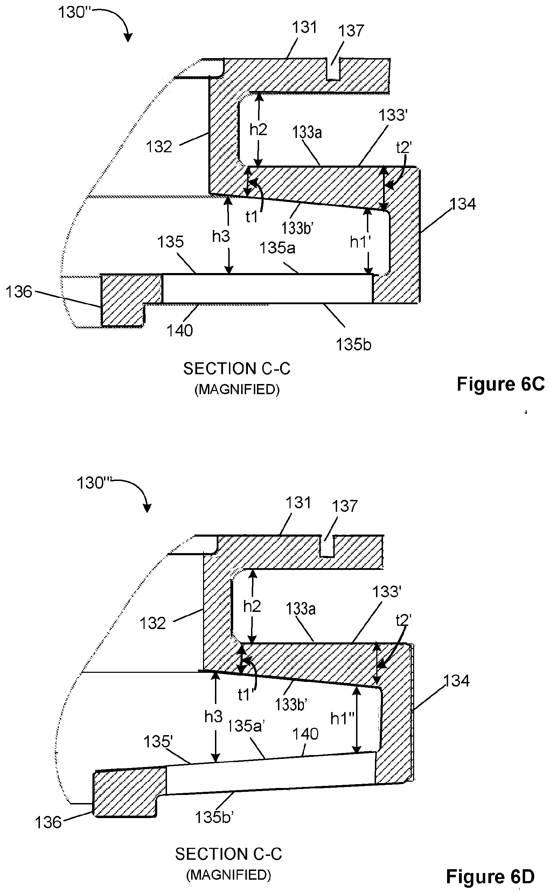

Figure 6C illustrates another alternate implementation of the S-shaped confinement ring 130" disposed in the plasma processing chamber 100. Figure 6C shows a magnified view of section C-C of the S-shaped confinement ring 130 identified in Figure 4. In this implementation, the S-shaped confinement ring 130" includes a mid-section 133' with a geometric profile that is different from the mid-section 133 illustrated in Figures 6A and 6B. The mid-section 133' is defined by a top surface 133a and a bottom surface 133b'. In the implementation of Figure 6C, the top surface 133a is defined as a flat surface while the bottom surface 133b' has a slope that extends down from the upper vertical section 132 (i.e., from the inner upper radius) to the lower vertical section 134 (i.e., to the second outer radius). An angle of slope may be defined based on amount of internal volume 108b desired in the plasma region 108. In some implementations, the amount of internal volume 108b to be reduced may be driven by the type of gases in the plasma region 108, for example. In this implementation, the top and the bottom surfaces (131a, 131b, 135a, 135b) of both the upper horizontal section 131 and lower horizontal section 135 are flat, except at the inner edge of the top surface of the upper horizontal section 131, which includes a step 148 configured to support a lip extension of the outer electrode 102b. The slope defined in the mid-section 133' results in variance in the heights proximate to the inner upper radius and the second outer radius and variance in thickness along a length of the mid-section 133'. For instance, the height h1' defined between the top surface 135a of the lower horizontal section 135 and the sloped bottom surface 133b' of the mid-section 133' proximate to the second outer radius is less than the height h3 defined between the top surface 135a of the lower horizontal section 135 and the sloped bottom surface 133b' of the mid-section 133' proximate to the inner upper radius, whereas in the implementations illustrated in Figures 6A and 6B, the heights h1 and h3 were shown to be equal. The height h2 between the bottom surface 131b of the upper horizontal section 131 and the top surface 133a of the mid-section 133' proximate to the inner upper radius remains the same as the implementations illustrated in Figures 6A and 6B. Similarly, the thickness t1 of the mid-section 133' proximate to the inner upper radius is less than the thickness t2' of the mid-section 133' proximate to the second outer radius. The variance in the thicknesses is attributed to the slope. The amount of variance depends on the angle of slope defined in the bottom surface 133b' of the mid-section 133'. In one implementation, the thickness t2' is defined to be about 10% to about 40% greater than the thickness t1. The slope in the mid-section 133' provides a way to reduce the volume in the plasma region 108 for receiving the plasma without requiring any re-design of other hardware components of the plasma processing chamber 100 and without compromising mechanical strength or usage life of the confinement ring 130".

Figure 6D illustrates an expanded cross-sectional view of the S-shaped confinement ring 130‴ used in the plasma processing chamber 100, in one implementation. In this implementation, the S-shaped confinement ring 130"' includes a different geometric profile of the mid-section and the lower horizontal section. For instance, the S-shaped confinement ring 130‴ includes a mid-section 133' with a slope defined in the bottom surface 133b' that extends down from the inner upper radius toward the second outer radius (similar to the geometric profile of the mid-section 133' shown in Figure 6C), and a lower horizontal section 135' that includes a slope in the top surface 135a' that extends down from the second outer radius to the inner lower radius of the confinement ring 130"'. In addition to the slope in the top surface 135a', a second slope is defined in the bottom surface 135b' of the lower horizontal section 135' that extends down from the second outer radius to the inner lower radius. In one implementation, the angle of slope of the top surface 135a' of the lower horizontal section 135' may be equal to the angle of second slope defined in the bottom surface 135b' of the lower horizontal section. In an alternate implementation, the angle of slope of the top surface 135a' of the lower horizontal section 135' may be lesser than or greater than the angle of the second slope defined in the bottom surface 135b' of the lower horizontal section 135'. Further, in one implementation, the angle of slope of the bottom surface 133b' of the mid-section 133' may be equal to the angle of slope of the top surface 135a' of the lower horizontal section 135'. In an alternate implementation, the angle of slope of the bottom surface 133b' of the mid-section 133' may be greater than or lesser than the angle of slope of the top surface 135a' of the lower horizontal section 135'. In another implementation, the top surface 135a' of the lower horizontal section 135 is defined to include a slope extending down from the second outer radius to the inner lower radius, while the bottom surface 135b of the lower horizontal section 135 is defined to be flat. In this implementation, the thickness of the lower horizontal section 135 varies along a length of the lower horizontal section 135 with the thickness proximate to the second outer radius being greater than the thickness proximate to the inner lower radius of the lower horizontal section 135. The amount of slope in the lower horizontal section 135 may be defined to ensure that the mechanical strength of the S-shaped confinement ring 130 is not compromised.

Due to the slopes defined in both the mid-section 133' and the lower horizontal section 135', the heights h1 and h3 may vary. Consequently, in the implementation illustrated in Figure 6D, the height h1" defined between the top surface 135a' of the lower horizontal section 135' and the bottom surface 133b' of the mid-section 133' at the second outer radius is less than the height h3 defined between the top surface 135a' of the lower horizontal section 135' and the bottom surface 133b' of the mid-section 133' at the inner upper radius. The height h3 may be equal to, greater than, or lesser than the height h2 defined between the top surface 133a of the mid-section 133 and the bottom surface 131b of the upper horizontal section 131. The cross-sectional view of Figure 6D is taken where a slot 140 is defined in the lower horizontal section 135'. It is to be noted that in the implementations illustrated in Figures 6C and 6D, the slopes along the bottom surface of the mid-section 133' and the top and bottom surfaces of the lower horizontal section 135' may be exaggerated to illustrate the presence of a slow and the actual angle of the respective slopes may be smaller than what is shown.

In one implementation, an angle of the slope defined in the bottom surface of the mid-section 133 to a horizontal x-axis may be defined to be equal to an angle of the slope defined on the top surface of the lower horizontal section 135. In alternate implementation, the angle of the slope in the bottom surface of the mid-section 133 to the horizontal x-axis may be defined to be greater than the angle of the slope defined on the top surface of the lower horizontal section 135. The aforementioned range for the angle of the slope in the mid-section 133 and the lower horizontal section 135 are provided as mere examples and should not be considered restrictive. Consequently, in some implementations, the angle of the slope in the mid-section 133 and/or in the lower horizontal section 135 can be envisioned to be greater or lesser than the aforementioned range, and such increase or decrease in the angle may be based on the inner dimensions of the plasma processing chamber 100, type of process that is being performed, amount of internal volume 108a that is desired in the plasma region 108, type of process gases used to generate the plasma, type of by-products and neutral gas species that are generated and need to be removed, access openings of the plasma processing chamber, etc. In one implementation, the confinement ring 130 is made of silicon. In other implementations, the confinement ring may be made of polysilicon, or silicon carbide, or boron carbide, or ceramic, or aluminum, or any other material that can withstand the processing conditions of the plasma region 108.

The lower horizontal section 135 includes a vertical extension 136 defined proximate to the inner lower radius. In one implementation illustrated in Figures 6A-6D, the inner edge of the vertical extension 136 is defined by a straight angle. In an alternate implementation, the inner edge of the vertical extension 136 may include an angled top section (angled at the inner side defined by the inner lower radius) and a vertical bottom section. The angled top section includes a slope at an inner edge defined at the inner lower radius. The vertical bottom section is disposed below the angled top section and extends vertically down for a height beyond the bottom surface 135b of the lower horizontal section 135. The vertical extension 136 provides a continuity to the lower horizontal section 135. A bottom surface of the vertical bottom section, in this implementation, is configured to rest on the RF gasket 116 disposed on the top surface of the ground bucket 124 defined in the lower electrode 104.

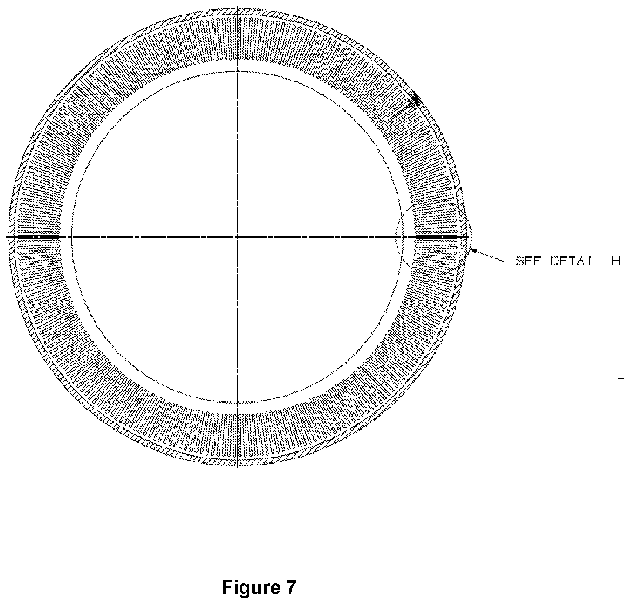

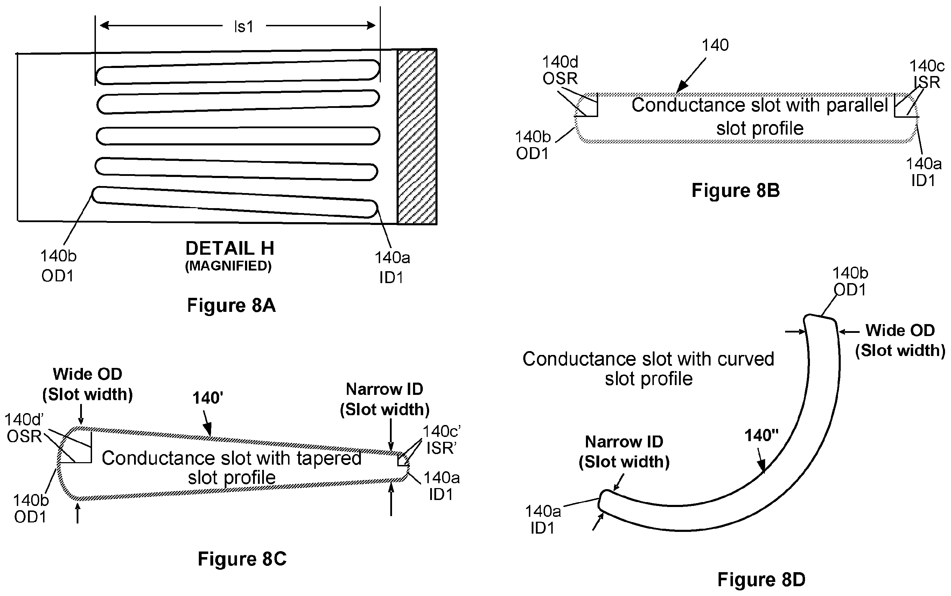

Figure 7 shows an overhead view of a bottom surface of the lower horizontal section 135 of the S-shaped confinement ring 130 used in the plasma processing chamber 100. The overhead view shows the slots 140 extending radially between an inner diameter and an outer diameter. The slots 140 conduct the by-products out of the plasma region 108, while effectively confining the plasma in the plasma region 108. The slots 140 extend from the top surface 135a to the bottom surface 135b of the lower horizontal section 135. The slots 140 may have a parallel slot profile, or a tapered slot profile, or a curved slot profile. Details of the parallel slot profile, the tapered slot profile and the curved slot profile will be described with reference to Figures 8A-8D.

Figure 8A illustrates an expanded view of a detail H identified in Figure 7. The detail H shows an expanded view of the slots 140 defined along the lower horizontal section 135 of the S-shaped confinement ring 130. As noted with reference to Figures 2-6D, the lower horizontal section 135 extends from the second outer radius to the inner lower radius. The slots 140 extend radially between the inner diameter (ID1) and the outer diameter (OD1) defined on the lower horizontal section 135 and for a slot length 'ls1'. In one implementation, the slot length ls1 is defined to be between about 40 mm (about 1.58 inches) and about 75 mm (about 2.95 inches). In some implementations, the inner diameter (ID1) of the slots 140 is greater than inner ring diameter (IRD) defined by the inner lower radius of the lower horizontal section 135. In some implementations, the outer diameter (OD1) of the slots 140 is greater than the ID1 and the IRD but is less than outer ring diameter (ORD) defined by the second outer radius of the lower horizontal section 135.

Figure 8B illustrates an expanded view of one of the slots 140 defined on the lower horizontal section 135 of the S-shaped confinement ring 130, in one implementation. The slots 140 are used to conduct the by-products out of the plasma region 108 while effectively confining the plasma within the plasma region 108, and hence are also referred to as conductance slots. Each slot 140, in this implementation, is defined to have a parallel slot profile. Accordingly, an inner slot radius (ISR) 140c at the inner diameter (ID1) 140a is equal to an outer slot radius (OSR) 140d at the outer diameter (OD1) 140b, and the width of the slot 140 defined by the ISR and the OSR is uniform along a length ls1 of the slot 140. When the wear at the ID1 140a or the OD1 140b reaches critical dimension, the confinement ring 130 may have to be replaced in order to avoid plasma unconfinement event from occurring.

Figure 8C illustrates an expanded view of a slot 140' defined on the lower horizontal section 135 of the S-shaped confinement ring 130, wherein the slot 140' is defined to have a tapered slot profile, in one implementation. The tapered slot profile includes a taper that tapers down from the outer diameter (OD1) 140b to the inner diameter (ID1) 140a, such that the slot 140' is broader at the OD1 140b and narrower at the ID1 140a. In this implementation, the inner slot radius (ISR) 140c' at the inner diameter (ID1) 140a is defined to be smaller than the outer slot radius (OSR) 140d' at the outer diameter (OD1) 140b. In one implementation, a ratio of the ISR 140c' to the OSR 140d' may be defined to be between about 1:1.1 and about 1:1.5. The ratio is provided as a mere example and that other ratios may also be envisioned. To compensate for the narrow ISR 140c', in one implementation, the length ls1 of the slot 140' may be increased to provide additional slot area for the by-products and neutral gas species to escape from the plasma region 108. In an alternate implementation, a number of slots 140' may be increased in addition to or instead of increasing the length ls1, to compensate for the narrow ISR 140c'.

The amount of taper defined by the ISR 140c' and the OSR 140d' is defined to be an inverse of wear rate at the corresponding ID1 140a and the OD1 140b. The wear along the length of the slot 140' is uneven due to amount of exposure the different portions along the length of the slot 140' have to the plasma within the plasma region 108, with the area of the slot 140' at the ID1 140a getting more wear than the area of the slot 140' at the OD1 140b. As the slot wear varies along the slot length, sizing the slot taper as a function of the wear rate ensures that the high wear rate at the ID1 140a is compensated for by the low wear rate at the OD1 140b, thereby resulting in an approximate straight slot profile at end of life of the confinement ring. The tapered profile of the slot 140' provides more area at the ID1 140a for the slot wear than at the OD1 140b so that the tapered slot 140' as a whole can reach the critical dimension at about the same time when the confinement ring 130' needs to be replaced. To compensate for the open areas in the lower horizontal section due to decrease in the dimension of the slot at the inner diameter, additional slots may be defined. The number of additional slots may be defined by taking into consideration the amount of wear space required at the narrow end and the broad end for each slot 140' to reach the critical dimension. The tapered slot geometry extends the amount of wear the slot can tolerate before reaching the unconfinement limit, resulting in longer usage life and improved cost of consumables. Even with the taper slot profile of the slots 140', the size of the ISR 140c' and the OSR 140d' are defined to enable removal of the by-products and the neutral gas species from the plasma region 108. The slots 140 of Figure 8B and 140' of Figure 8C are not drawn to scale, but have been exaggerated in order to illustrate the different dimensions.

For more information with regards to use of tapered slot profile for defining the slots 140' along the lower horizontal section 135 of the confinement ring, reference can be made to co-owned document US 2023/0369028 A1, filed on October 30, 2020, and entitled "Wear Compensating Confinement Ring". Variations in the design of the confinement ring 130, such as defining slope along the top surface 135a of the lower horizontal section 135 and slots 140 with the parallel slot profile, or defining slope along the top surface 135a of the lower horizontal section 135 and slots 140' with tapered slot profile may also be envisioned to improve the plasma density across the length of the substrate surface.

Figure 8D illustrates an expanded view of a slot 140" defined in the lower horizontal section 135 of the S-shaped confinement ring 130, wherein the slot 140" is defined to include a curved slot profile, in yet another implementation. Although not shown in Figure 8A, the curved slot profile may be used to increase a length ls1 of the slot 140" for the by-products to escape. The angle of curvature of the curved slot 140" may be based on the amount of length to which the slot 140" needs to be increased to efficiently conduct the by-products out of the plasma region 108. The curved slot 140", in one implementation (not shown), may include a parallel slot profile with the inner slot radius 140c at the ID1 140a equal to the outer slot radius 140d at the OD1 140b, as was discussed with reference to Figure 8B, but with the profile of the slot being curved along the length of the slot 140". In an alternate implementation shown in Figure 8D, the curved slot 140" may include a tapered slot profile with the ISR 140c' at the ID1 140a being less than the OSR 140d' at the OD1 140b, as was discussed with reference to Figure 8C, but with the profile of the slot being curved along the length of the slot 140". As can be seen, there may be variations in the shape of the slots defined on the lower horizontal section 135. The variations in the shapes may be based on types of gases used for generating the plasma, the type of by-products being removed, the amount of area needed to remove the by-products out of the plasma region, optimal plasma confinement in the plasma region, etc. The shapes and different sizes of the slots illustrated in Figures 8B-8D are some examples, and that other shapes and sizes for the slots may also be envisioned.

The advantages of the S-shaped confinement ring described in the various implementations include improving plasma density uniformity without adversely affecting other hardware components (e.g., chamber spacer plate, mating hardware, etc.) or adversely impacting the mechanical strength or lifetime usage of the confinement ring. Further, the S-shape assists in reducing volume within the plasma region, which can result in less amount of gas(es) required for generating the plasma to fill the reduced volume of the plasma region, thereby conserving the process gas(es) used. Further adjustment to the volume and the plasma density uniformity can be modulated by providing modifications to the shape of the different surfaces of the confinement ring (i.e., providing slants on a bottom surface of the mid-section and/or the top surface of the lower horizontal section) without affecting the strength or the original lifetime usage of the confinement ring. This results in improved substrate etch uniformity and improved cost of the consumable confinement ring as the confinement ring can withstand more process operations before reaching the critical dimension limits along the lower horizontal section and along the length of the slot. Other advantages will be envisioned by one skilled in the art upon reviewing the various implementations described herein.

## Claims

1. A confinement ring (130) for use in a plasma processing chamber (100), comprising:
an upper horizontal section (131) extending between an inner upper radius (152) and a first outer radius (150);
a mid-section (133) extending between the inner upper radius and a second outer radius (151);
a lower horizontal section (135) extending between an inner lower radius (153) and the second outer radius;
an upper vertical section (132) extending between the upper horizontal section and the mid-section proximate to the inner upper radius;
a lower vertical section (134) extending between the mid-section and the lower horizontal section proximate to the second outer radius; and
a vertical extension (136) extending downward from the lower horizontal section proximate to the inner lower radius.

2. The confinement ring of claim 1, wherein a plasma volume (108) is disposed between an upper electrode structure (102), a lower electrode (104) and the confinement ring (130) of the plasma processing chamber.

3. The confinement ring of claim 2, wherein the plasma volume includes an external volume (108a) and an internal volume (108b), the external volume is defined between the upper horizontal section, the upper vertical section and the mid-section, the external volume is defined in the area immediately below the upper electrode structure (102) and outside of the internal volume, and wherein the internal volume is defined between the mid-section, the lower vertical section and the lower horizontal section, the internal volume is inside the plasma volume and is defined between the external volume and a substrate support surface of the lower electrode.

4. The confinement ring of claim 1, wherein a length of the mid-section and a length of the lower horizontal section are of a uniform thickness.

5. The confinement ring of claim 1, wherein a top surface (133a) of the mid-section includes a flat profile and a bottom surface (133b) of the mid-section is angled down from the inner upper radius toward the second outer radius, wherein a first thickness of the mid-section proximate to the inner upper radius is less than a second thickness of the mid-section proximate to the second outer radius.

6. The confinement ring of claim 1, wherein a first height (h1) defined between a top surface of the lower horizontal section and a bottom surface of the mid-section proximate to the second outer radius is less than a second height (h2) defined between a top surface of the mid-section and a bottom surface of the upper horizontal section proximate to the inner upper radius.

7. The confinement ring of claim 1, wherein a first height defined between a top surface of the lower horizontal section and a bottom surface of the mid-section proximate to the second outer radius is equal to a second height defined between a top surface of the mid-section and a bottom surface of the upper horizontal section proximate to the inner upper radius and to a third height (h3) defined between the top surface of the lower horizontal section and the bottom surface of the mid-section proximate to the inner upper radius.

8. The confinement ring of claim 1, wherein the second outer radius extends beyond the first outer radius, the second outer radius defining an outer radius of the confinement ring, and
wherein the inner upper radius is greater than the inner lower radius.

9. The confinement ring of claim 1, wherein the lower horizontal section includes a plurality of slots (140), each slot of the plurality of slots extends radially from an inner diameter (140a) to an outer diameter (140b) along the lower horizontal section, wherein the inner diameter from where each slot extends is greater than an inner ring diameter (IRD) of the confinement ring defined by the inner lower radius, and the outer diameter from where said each slot extends is less than an outer ring diameter (ORD) of the confinement ring defined by the second outer radius, each slot extending from a top surface (135a) to a bottom surface (135b) of the lower horizontal section.

10. The confinement ring of claim 9, wherein an inner slot radius (140c) of each slot at the inner diameter is less than an outer slot radius (140d) of each slot at the outer diameter,
wherein a difference in the inner slot radius and the outer slot radius of each slot defines a slot taper, each slot tapers down from the outer diameter to the inner diameter, wherein the inner slot radius and the outer slot radius influencing the slot taper are defined to be an inverse of a wear rate at the corresponding inner diameter and the outer diameter of the slot.

11. The confinement ring of claim 1, wherein the upper horizontal section, the upper vertical section, the mid-section, the lower vertical section and the lower horizontal section form a unitary S-shaped structure, and the vertical extension defined proximate to the inner lower radius integrally continues the S-shaped structure downward, the unitary S-shaped structure configured to confine plasma within a plasma region defined in the plasma processing chamber.

12. The confinement ring of claim 1, wherein the lower horizontal section includes a slope that extends down from the lower vertical section toward the inner lower radius, wherein a thickness along a length of the lower horizontal section is uniform, and wherein the vertical extension is defined by an angled top section and a vertical bottom section, the angled top section is defined on a top surface of the lower horizontal section proximate to the inner lower radius and the vertical bottom section is defined to extend downward from a bottom portion of the angled top section proximate to the inner lower radius.

13. The confinement ring of claim 1, wherein a top surface (131a) of the upper horizontal section includes a plurality of holes (137) to receive cam keys for coupling the confinement ring to corresponding cam locks disposed on a bottom surface of a backing plate (105) disposed in the plasma processing chamber, each cam key is disposed to align with a corresponding cam lock.

14. A plasma processing chamber (100) for confining plasma, including,
a lower electrode (104) disposed in a lower portion of the plasma processing chamber, the lower electrode including a support surface for supporting a substrate (110);
an upper electrode structure (102) disposed in an upper portion of the plasma processing chamber and oriented opposite the lower electrode;
a confinement ring (130) according to claim 1, the confinement ring being coupled to a portion of the upper electrode structure and disposed between the upper electrode structure and the lower electrode.

15. The plasma processing chamber of claim 14, wherein the upper electrode structure includes,
an upper electrode (102a) disposed in center of the upper electrode structure;
an outer electrode (102b) disposed adjacent to the upper electrode; and
a backing plate (105) disposed to surround the outer electrode, the backing plate having an outer portion (105a) that is disposed adjacent to the outer electrode such that the outer electrode is disposed between the upper electrode and the outer portion of the backing plate, and an inner portion (105b) that is disposed over a portion of the outer electrode, a bottom surface of the outer portion of the backing plate including a plurality of cam locks that align with corresponding cam keys of the plurality of cam keys disposed on a top surface of the upper horizontal section of the confinement ring, the plurality of cam keys and the plurality of cam locks used to couple the outer electrode to the confinement ring, and
wherein the backing plate and the upper electrode of the upper electrode structure are electrically grounded, the lower electrode coupled to a radio frequency, RF, generator (106) via a corresponding match network (107), the RF generator providing RF power to the lower electrode for generating plasma within the plasma processing chamber.

## Patentansprüche

1. Confinement-Ring (130) zur Verwendung in einer Plasmaverarbeitungskammer (100), umfassend:
einen oberen horizontalen Abschnitt (131), der sich zwischen einem inneren oberen Radius (152) und einem ersten äußeren Radius (150) erstreckt;
einen Mittelabschnitt (133), der sich zwischen dem inneren oberen Radius und einem zweiten äußeren Radius (151) erstreckt;
einen unteren horizontalen Abschnitt (135), der sich zwischen einem inneren unteren Radius (153) und dem zweiten äußeren Radius erstreckt;
einen oberen vertikalen Abschnitt (132), der sich zwischen dem oberen horizontalen Abschnitt und dem Mittelabschnitt nahe des inneren oberen Radius erstreckt;
einen unteren vertikalen Abschnitt (134), der sich zwischen dem Mittelabschnitt und dem unteren horizontalen Abschnitt nahe des zweiten äußeren Radius erstreckt; und
eine vertikale Erstreckung (136), die sich von dem unteren horizontalen Abschnitt nahe des inneren unteren Radius nach unten erstreckt.

2. Confinement-Ring nach Anspruch 1, wobei ein Plasmavolumen (108) zwischen einer oberen Elektrodenstruktur (102), einer unteren Elektrode (104) und dem Confinement-Ring (130) der Plasmaverarbeitungskammer angeordnet ist.

3. Confinement-Ring nach Anspruch 2, wobei das Plasmavolumen ein externes Volumen (108a) und ein internes Volumen (108b) umfasst, wobei das externe Volumen zwischen dem oberen horizontalen Abschnitt, dem oberen vertikalen Abschnitt und dem Mittelabschnitt definiert ist, wobei das externe Volumen in dem Bereich unmittelbar unterhalb der oberen Elektrodenstruktur (102) und außerhalb des internen Volumens definiert ist, und wobei das interne Volumen zwischen dem Mittelabschnitt, dem unteren vertikalen Abschnitt und dem unteren horizontalen Abschnitt definiert ist, wobei das interne Volumen innerhalb des Plasmavolumens ist und zwischen dem externen Volumen und einer Substratträgeroberfläche der unteren Elektrode definiert ist.

4. Confinement-Ring nach Anspruch 1, wobei eine Länge des Mittelabschnitts und eine Länge des unteren horizontalen Abschnitts eine einheitliche Dicke aufweisen.

5. Confinement-Ring nach Anspruch 1, wobei eine Oberseite (133a) des Mittelabschnitts ein flaches Profil umfasst und eine Unterseite (133b) des Mittelabschnitts von dem inneren oberen Radius in Richtung des zweiten äußeren Radius nach unten geneigt ist, wobei eine erste Dicke des Mittelabschnitts nahe des inneren oberen Radius kleiner ist als eine zweite Dicke des Mittelabschnitts nahe des zweiten äußeren Radius.

6. Confinement-Ring nach Anspruch 1, wobei eine erste Höhe (h1), die zwischen einer Oberseite des unteren horizontalen Abschnitts und einer Unterseite des Mittelabschnitts nahe des zweiten äußeren Radius definiert ist, kleiner ist als eine zweite Höhe (h2), die zwischen einer Oberseite des Mittelabschnitts und einer Unterseite des oberen horizontalen Abschnitts nahe des inneren oberen Radius definiert ist.

7. Confinement-Ring nach Anspruch 1, wobei eine erste Höhe, die zwischen einer Oberseite des unteren horizontalen Abschnitts und einer Unterseite des Mittelabschnitts nahe des zweiten äußeren Radius definiert ist, gleich einer zweiten Höhe ist, die zwischen einer Oberseite des Mittelabschnitts und einer Unterseite des oberen horizontalen Abschnitts nahe des inneren oberen Radius definiert ist, und gleich einer dritten Höhe (h3) ist, die zwischen der Oberseite des unteren horizontalen Abschnitts und der Unterseite des Mittelabschnitts nahe des inneren oberen Radius definiert ist.

8. Confinement-Ring nach Anspruch 1, wobei sich der zweite äußere Radius über den ersten äußeren Radius hinaus erstreckt, wobei der zweite äußere Radius einen äußeren Radius des Confinement-Rings definiert, und
wobei der innere obere Radius größer ist als der innere untere Radius.

9. Confinement-Ring nach Anspruch 1, wobei der untere horizontale Abschnitt eine Vielzahl von Schlitzen (140) umfasst, wobei sich jeder Schlitz aus der Vielzahl von Schlitzen radial von einem inneren Durchmesser (140a) bis zu einem äußeren Durchmesser (140b) entlang des unteren horizontalen Abschnitts erstreckt, wobei der innere Durchmesser, von dem sich jeder Schlitz erstreckt, größer ist als ein innerer Ringdurchmesser (IRD) des Confinement-Rings, der durch den inneren unteren Radius definiert ist, und wobei der äußere Durchmesser, von dem sich der Schlitz erstreckt, kleiner ist als ein äußerer Ringdurchmesser (ORD) des Confinement-Rings, der durch den zweiten äußeren Radius definiert ist, wobei sich jeder Schlitz von einer Oberseite (135a) bis zu einer Unterseite (135b) des unteren horizontalen Abschnitts erstreckt.

10. Confinement-Ring nach Anspruch 9, wobei ein innerer Schlitzradius (140c) jedes Schlitzes an dem inneren Durchmesser kleiner ist als ein äußerer Schlitzradius (140d) jedes Schlitzes an dem äußeren Durchmesser,
wobei eine Differenz zwischen dem inneren Schlitzradius und dem äußeren Schlitzradius jedes Schlitzes eine Schlitzverjüngung definiert, wobei sich jeder Schlitz von dem äußeren Durchmesser bis zum inneren Durchmesser nach unten hin verjüngt, wobei der innere Schlitzradius und der äußere Schlitzradius, die die Schlitzverjüngung beeinflussen, definiert sind, um ein Kehrwert einer Verschleißrate an dem entsprechenden inneren Durchmesser und dem äußeren Durchmesser des Schlitzes zu sein.

11. Confinement-Ring nach Anspruch 1, wobei der obere horizontale Abschnitt, der obere vertikale Abschnitt, der Mittelabschnitt, der untere vertikale Abschnitt und der untere horizontale Abschnitt eine einheitliche S-förmige Struktur bilden, und wobei die vertikale Erstreckung, die nahe des inneren unteren Radius definiert ist, die S-förmige Struktur einstückig nach unten fortsetzt, wobei die einheitliche S-förmige Struktur ausgelegt ist, um Plasma innerhalb eines Plasmabereichs, der in der Plasmaverarbeitungskammer definiert ist, einzuschließen.

12. Confinement-Ring nach Anspruch 1, wobei der untere horizontale Abschnitt eine Neigung umfasst, die sich von dem unteren vertikalen Abschnitt hin zu dem inneren unteren Radius erstreckt, wobei eine Dicke entlang einer Länge des unteren horizontalen Abschnitts einheitlich ist, und wobei die vertikale Erstreckung durch einen geneigten oberen Abschnitt und einen vertikalen unteren Abschnitt definiert ist, wobei der geneigte obere Abschnitt auf einer Oberseite des unteren horizontalen Abschnitts nahe des inneren unteren Radius definiert ist, und der vertikale untere Abschnitt definiert ist, um sich von einem unteren Abschnitt des geneigten oberen Abschnitts nahe des inneren unteren Radius nach unten zu erstrecken.

13. Confinement-Ring nach Anspruch 1, wobei eine Oberseite (131a) des oberen horizontalen Abschnitts eine Vielzahl von Löchern (137) umfasst, um Nockennasen zum Koppeln des Confinement-Rings an entsprechende Nockenverschlüsse, die auf einer Unterseite einer Trägerplatte (105), die in der Plasmaverarbeitungskammer angeordnet ist, aufzunehmen, wobei jede Nockennase angeordnet ist, um an einem entsprechenden Nockenverschluss ausgerichtet zu sein.

14. Plasmaverarbeitungskammer (100) zum Einschließen von Plasma, umfassend eine untere Elektrode (104), die in einem unteren Abschnitt der Plasmaverarbeitungskammer angeordnet ist, wobei die untere Elektrode eine Trägeroberfläche zum Tragen eines Substrats (110) umfasst;
eine obere Elektrodenstruktur (102), die in einem oberen Abschnitt der Plasmaverarbeitungskammer angeordnet ist und gegenüberliegend der unteren Elektrode ausgerichtet ist;
einen Confinement-Ring (130) nach Anspruch 1, wobei der Confinement-Ring mit einem Abschnitt der oberen Elektrodenstruktur gekoppelt ist und zwischen der oberen Elektrodenstruktur und der unteren Elektrode angeordnet ist.

15. Plasmaverarbeitungskammer nach Anspruch 14, wobei die obere Elektrodenstruktur Folgendes umfasst:
eine obere Elektrode (102a), die in der Mitte der oberen Elektrodenstruktur angeordnet ist;
eine äußere Elektrode (102b), die benachbart zu der oberen Elektrode angeordnet ist; und
eine Trägerplatte (105), die angeordnet ist, um die äußere Elektrode zu umgeben, wobei die Trägerplatte einen äußeren Abschnitt (105a), der benachbart zu der äußeren Elektrode angeordnet ist, sodass die äußere Elektrode zwischen der oberen Elektrode und dem äußeren Abschnitt der Trägerplatte angeordnet ist, und einen inneren Abschnitt (105b) umfasst, der über einem Abschnitt der äußeren Elektrode angeordnet ist, wobei eine Unterseite des äußeren Abschnitts der Trägerplatte eine Vielzahl von Nockenverschlüssen umfasst, die an entsprechenden Nockennasen aus der Vielzahl von Nockennasen, die auf einer Oberseite des oberen horizontalen Abschnitts des Confinement-Rings angeordnet sind, auszurichten sind, wobei die Vielzahl von Nockennasen und die Vielzahl von Nockenverschlüssen verwendet werden, um die äußere Elektrode mit dem Confinement-Ring zu koppeln, und
wobei die Trägerplatte und die obere Elektrode der oberen Elektrodenstruktur elektrisch mit Masse verbunden sind, wobei die untere Elektrode über ein entsprechendes Anpassungsnetzwerk (107) mit einem Hochfrequenz-, HF-, Generator (106) gekoppelt ist, wobei der HF-Generator HF-Leistung an der unteren Elektrode zum Erzeugen von Plasma innerhalb der Plasmaverarbeitungskammer bereitstellt.

## Revendications

1. Anneau de confinement (130) à utiliser dans une chambre de traitement au plasma (100), comprenant :
une section horizontale supérieure (131) s'étendant entre un rayon supérieur intérieur (152) et un premier rayon extérieur (150) ;
une section médiane (133) s'étendant entre le rayon supérieur intérieur et un second rayon extérieur (151) ;
une section horizontale inférieure (135) s'étendant entre un rayon inférieur intérieur (153) et le second rayon extérieur ;
une section verticale supérieure (132) s'étendant entre la section horizontale supérieure et la section médiane à proximité du rayon supérieur intérieur ;
une section verticale inférieure (134) s'étendant entre la section médiane et la section horizontale inférieure à proximité du second rayon extérieur ; et
une extension verticale (136) s'étendant vers le bas à partir de la section horizontale inférieure à proximité du rayon inférieur intérieur.

2. Anneau de confinement selon la revendication 1, dans lequel un volume de plasma (108) est disposé entre une structure d'électrode supérieure (102), une électrode inférieure (104) et l'anneau de confinement (130) de la chambre de traitement au plasma.

3. Anneau de confinement selon la revendication 2, dans lequel le volume de plasma inclut un volume externe (108a) et un volume interne (108b), le volume externe est défini entre la section horizontale supérieure, la section verticale supérieure et la section médiane, le volume externe est défini dans la zone immédiatement en dessous de la structure d'électrode supérieure (102) et à l'extérieur du volume interne, et dans lequel le volume interne est défini entre la section médiane, la section verticale inférieure et la section horizontale inférieure, le volume interne est à l'intérieur du volume de plasma et est défini entre le volume externe et une surface de support de substrat de l'électrode inférieure.

4. Anneau de confinement selon la revendication 1, dans lequel une longueur de la section médiane et une longueur de la section horizontale inférieure sont d'une épaisseur uniforme.

5. Anneau de confinement selon la revendication 1, dans lequel une surface supérieure (133a) de la section médiane inclut un profil plat et une surface inférieure (133b) de la section médiane est inclinée vers le bas à partir du rayon supérieur intérieur vers le second rayon extérieur, dans lequel une première épaisseur de la section médiane à proximité du rayon supérieur intérieur est inférieure à une seconde épaisseur de la section médiane à proximité du second rayon extérieur.

6. Anneau de confinement selon la revendication 1, dans lequel une première hauteur (h1) définie entre une surface supérieure de la section horizontale inférieure et une surface inférieure de la section médiane à proximité du second rayon extérieur est inférieure à une seconde hauteur (h2) définie entre une surface supérieure de la section médiane et une surface inférieure de la section horizontale supérieure à proximité du rayon supérieur intérieur.

7. Anneau de confinement selon la revendication 1, dans lequel une première hauteur définie entre une surface supérieure de la section horizontale inférieure et une surface inférieure de la section médiane à proximité du second rayon extérieur est égale à une deuxième hauteur définie entre une surface supérieure de la section médiane et une surface inférieure de la section horizontale supérieure à proximité du rayon supérieur intérieur et à une troisième hauteur (h3) définie entre la surface supérieure de la section horizontale inférieure et la surface inférieure de la section médiane à proximité du rayon supérieur intérieur.

8. Anneau de confinement selon la revendication 1, dans lequel le second rayon extérieur s'étend au-delà du premier rayon extérieur, le second rayon extérieur définissant un rayon extérieur de l'anneau de confinement, et
dans lequel le rayon supérieur intérieur est supérieur au rayon inférieur intérieur.

9. Anneau de confinement selon la revendication 1, dans lequel la section horizontale inférieure inclut une pluralité de fentes (140), chaque fente de la pluralité de fentes s'étend radialement d'un diamètre intérieur (140a) à un diamètre extérieur (140b) le long de la section horizontale inférieure, dans lequel le diamètre intérieur à partir duquel chaque fente s'étend est supérieur à un diamètre d'anneau intérieur (IRD) de l'anneau de confinement défini par le rayon inférieur intérieur, et le diamètre extérieur à partir duquel ladite chaque fente s'étend est inférieur à un diamètre d'anneau extérieur (ORD) de l'anneau de confinement défini par le second rayon extérieur, chaque fente s'étendant d'une surface supérieure (135a) à une surface inférieure (135b) de la section horizontale inférieure.

10. Anneau de confinement selon la revendication 9, dans lequel un rayon de fente intérieur (140c) de chaque fente au niveau du diamètre intérieur est inférieur à un rayon de fente extérieur (140d) de chaque fente au niveau du diamètre extérieur,
dans lequel une différence dans le rayon de fente intérieur et le rayon de fente extérieur de chaque fente définit une conicité de fente, chaque fente est conique du diamètre extérieur au diamètre intérieur, dans lequel le rayon de fente intérieur et le rayon de fente extérieur influençant la conicité de fente sont définis comme étant un inverse d'un taux d'usure au niveau du diamètre intérieur correspondant et au niveau du diamètre extérieur de la fente.

11. Anneau de confinement selon la revendication 1, dans lequel la section horizontale supérieure, la section verticale supérieure, la section médiane, la section verticale inférieure et la section horizontale inférieure forment une structure unitaire en forme de S, et l'extension verticale définie à proximité du rayon inférieur intérieur prolonge intégralement la structure en forme de S vers le bas, la structure unitaire en forme de S étant configurée pour confiner le plasma dans une région de plasma définie dans la chambre de traitement au plasma.

12. Anneau de confinement selon la revendication 1, dans lequel la section horizontale inférieure inclut une pente qui s'étend vers le bas à partir de la section verticale inférieure vers le rayon inférieur intérieur, dans lequel une épaisseur le long d'une longueur de la section horizontale inférieure est uniforme, et dans lequel l'extension verticale est définie par une section supérieure angulaire et une section inférieure verticale, la section supérieure angulaire est définie sur une surface supérieure de la section horizontale inférieure à proximité du rayon inférieur intérieur et la section inférieure verticale est définie pour s'étendre vers le bas à partir d'une partie inférieure de la section supérieure angulaire à proximité du rayon inférieur intérieur.

13. Anneau de confinement selon la revendication 1, dans lequel une surface supérieure (131a) de la section horizontale supérieure inclut une pluralité de trous (137) pour recevoir des clés de came pour coupler l'anneau de confinement à des verrous de came correspondants disposés sur une surface inférieure d'une plaque de support (105) disposée dans la chambre de traitement au plasma, chaque clé de came étant disposée pour s'aligner avec un verrou de came correspondant.

14. Chambre de traitement au plasma (100) pour confiner du plasma, incluant :
une électrode inférieure (104) disposée dans une partie inférieure de la chambre de traitement au plasma, l'électrode inférieure incluant une surface de support pour supporter un substrat (110) ;
une structure d'électrode supérieure (102) disposée dans une partie supérieure de la chambre de traitement au plasma et orientée à l'opposé de l'électrode inférieure ;
un anneau de confinement (130) selon la revendication 1, l'anneau de confinement étant couplé à une partie de la structure d'électrode supérieure et disposé entre la structure d'électrode supérieure et l'électrode inférieure.

15. Chambre de traitement au plasma selon la revendication 14, dans laquelle la structure d'électrode supérieure inclut une électrode supérieure (102a) disposée au centre de la structure d'électrode supérieure ;
une électrode extérieure (102b) disposée adjacente à l'électrode supérieure ; et
une plaque de support (105) disposée pour entourer l'électrode extérieure, la plaque de support présentant une partie extérieure (105a) qui est disposée adjacente à l'électrode extérieure de telle sorte que l'électrode extérieure soit disposée entre l'électrode supérieure et la partie extérieure de la plaque de support, et une partie intérieure (105b) qui est disposée sur une partie de l'électrode extérieure, une surface inférieure de la partie extérieure de la plaque de support incluant une pluralité de verrous de came qui s'alignent avec des clés de came correspondantes de la pluralité de clés de came disposées sur une surface supérieure de la section horizontale supérieure de l'anneau de confinement, la pluralité de clés de came et la pluralité de verrous de came étant utilisées pour coupler l'électrode extérieure à l'anneau de confinement, et
dans laquelle la plaque de support et l'électrode supérieure de la structure d'électrode supérieure sont mises à la terre électriquement, l'électrode inférieure étant couplée à un générateur radiofréquence, RF, (106) via un réseau d'adaptation correspondant (107), le générateur RF fournissant une puissance RF à l'électrode inférieure pour générer un plasma à l'intérieur de la chambre de traitement au plasma.
